(19) Europäisches Patentamt
European Patent Office
Office européen des brevets

(11) **EP 4 078 249 B1**

(12) **EUROPÄISCHE PATENTSCHRIFT**

(45) Veröffentlichungstag und Bekanntmachung des Hinweises auf die Patenterteilung:
**10.12.2025 Patentblatt 2025/50**

(21) Anmeldenummer: **20842564.5**

(22) Anmeldetag: **18.12.2020**

(51) Internationale Patentklassifikation (IPC):
*G02B 1/115* (2015.01)   *B29D 11/00* (2006.01)
*C23C 14/54* (2006.01)   *C23C 16/12* (2006.01)
*G01B 11/06* (2006.01)   *G02B 5/28* (2006.01)
*G02B 27/00* (2006.01)

(52) Gemeinsame Patentklassifikation (CPC):
**G02B 1/115; B29D 11/00865; B29D 11/0098; C23C 16/006; C23C 16/52; G02B 5/285; G02B 27/0012**

(86) Internationale Anmeldenummer:
**PCT/EP2020/087007**

(87) Internationale Veröffentlichungsnummer:
**WO 2021/123154 (24.06.2021 Gazette 2021/25)**

(54) **VERFAHREN ZUM BETREIBEN EINES BESCHICHTUNGSSYSTEMS ZUR HERSTELLUNG VON SCHICHTSYSTEMEN**

METHOD FOR OPERATING A COATING SYSTEM FOR PRODUCING LAYER SYSTEMS

PROCÉDÉ POUR FAIRE FONCTIONNER UN SYSTÈME DE REVÊTEMENT POUR RÉALISER DES SYSTÈMES DE COUCHES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.12.2019 DE 102019135195**

(43) Veröffentlichungstag der Anmeldung:
**26.10.2022 Patentblatt 2022/43**

(73) Patentinhaber: **Rodenstock GmbH**
**80687 München (DE)**

(72) Erfinder:
• SCHERSCHLICHT, Rüdiger
  **82008 Unterhaching (DE)**
• RADÜNZ, Stefan
  **82205 Gilching (DE)**

(74) Vertreter: **RPK Patentanwälte**
**Reinhardt und Kaufmann**
**Partnerschaft mbB**
**Gaisburgstraße 21**
**70182 Stuttgart (DE)**

(56) Entgegenhaltungen:
**DE-A1- 102011 084 996     US-A1- 2019 127 845**
**US-B1- 9 709 386**

• **MASSIMO LAZZARONI: "A tool for quality controls in industrial process", 2009 IEEE INTRUMENTATION AND MEASUREMENT TECHNOLOGY CONFERENCE (I2MTC) - 5-7 MAY 2009 - SINGAPORE, SINGAPORE, IEEE, PISCATAWAY, NJ, USA, 5 May 2009 (2009-05-05), pages 68 - 73, XP031492604, ISBN: 978-1-4244-3352-0**

EP 4 078 249 B1

## Beschreibung

### Stand der Technik

Die Erfindung betrifft ein Verfahren zum Betreiben eines Beschichtungssystems zur Herstellung von Schichtsystemen. Die Erfindung betrifft ferner ein Beschichtungssystem zur Herstellung von Schichtsystemen, ein Computer-Programm-Produkt für ein Verfahren zum Betreiben eines Beschichtungssystems, und ein Datenverarbeitungssystem zur Ausführung eines Verfahrens zum Betreiben eines Beschichtungssystems zur Herstellung von Schichtsystemen.

Ein in einem Fertigungsumfeld implementiertes Beschichtungsverfahren mit einem zugrundeliegenden Beschichtungsprozess weist üblicherweise Abweichungen von Beschichtungscharge zu Beschichtungscharge auf. Diese Abweichungen rühren daher, dass sich der Zustand der Beschichtungsanlage geringfügig verändert, beispielsweise durch Ablagerungen von Beschichtungsmaterial an den Wänden der Vakuumkammer, Bedienereinflüsse bei der Bestückung der Beschichtungsanlage mit Beschichtungsmaterial, Abnutzung diverser in der Beschichtungsanlage verbauten Komponenten und dergleichen.

Üblicherweise werden in Produktion-Monitoring-Tools zu den meisten Beschichtungschargen gemessene Reflexionskurven hinterlegt. Diese Kurven können innerhalb des Produktion-Monitoring-Tools bzgl. Rm (mittlerer Reflexionsgrad, Rv (visuelle Reflektivität) und ihrer Farbwerte ausgewertet und die entsprechenden Werte abgespeichert werden. Gleiches gilt für andere Eingabewerte wie z.B. Transmissionswert, Gitterschnittwert, etc.. Für verschiedene Schichtvarianten können beispielsweise aus Freigabegesichtspunkten qualitätsrelevante Größen indirekt bestimmt werden.

Bekannte optische Elemente mit interferometrischer Entspiegelung, wie sie etwa aus der WO 2016/110339 A1 bekannt sind, weisen üblicherweise einen Lichtreflexionsgrad von ungefähr 1% auf, berechnet nach der Norm DIN EN ISO 13666:2013-10. Die Farbe des verbleibenden Restreflexes kann eine starke Variation zeigen, wenn der Betrachtungswinkel geändert wird. Die Variation kann sich über die gesamte visuelle Farbskala erstrecken.

Aus der US 2019127845 A1 ist ein Verfahren zum Betreiben eines Schichtsystems bekannt, bei dem eine Vielzahl von Sputterkammern gleichzeitig betrieben werden, um einen Stapel von Dünnschichten aus zwei oder mehr verschiedenen Materialien auf einem Substrat abzuscheiden. Die Dicken der Dünnschichten werden aus den optischen Eigenschaften berechnet, die von der in einer Sputtervorrichtung ausgestatteten optischen Messeinheit erhalten werden. Die Messung der Dicken und die Einstellung der Abscheidebedingungen für die Dünnschichten werden so lange wiederholt, bis die von der optischen Messeinheit ermittelten optischen Eigenschaften oder die aus den optischen Eigenschaften berechnete Dicke der jeweiligen Dünnschichten in einen vorgegebenen Bereich fallen. Dabei erfolgt zunächst eine Vorabscheidung, bei der die Beschichtungsbedingungen während der laufenden Beschichtung angepasst werden, bevor eine Hauptabscheidung erfolgt.

### Offenbarung der Erfindung

Die Aufgabe der Erfindung ist es, ein Verfahren zum Betreiben eines Beschichtungssystems zur Herstellung von Schichtsystemen anzugeben, welches qualitätsrelevante Aspekte mit einbezieht.

Weitere Aufgaben der Erfindung sind, ein Beschichtungssystem sowie ein Computer-Programm-Produkt und ein Datenverarbeitungssystem zum Ausführen eines solchen Verfahrens anzugeben.

Die Aufgaben werden durch die Merkmale der unabhängigen Ansprüche gelöst. Günstige Ausgestaltungen und Vorteile der Erfindung ergeben sich aus den weiteren Ansprüchen, der Beschreibung und der Zeichnung.

Die Erfindung ist insbesondere für die Herstellung optischer Elemente geeignet. Es soll verstanden werden, dass das erfindungsgemäße Verfahren weder auf die Herstellung optischer Elemente und Beschichtungen beschränkt ist, noch auf die Abscheidung von Mehrschichtsystemen. Ebenso kann das Substrat, auf dem das Schichtsystem abgeschieden ist, bei Bedarf transparent sein oder nicht transparent.

Ferner kann die Erfindung für ein Schichtsystem eingesetzt werden, das aus einer Einzellage besteht, die auf einem Substrat abgeschieden ist und die eine Schichtdicke aufweist. Dies schließt nicht aus, dass zwischen Einzellage und Substrat eine Haftvermittlerschicht angeordnet ist und/oder die Einzellage mit einer Schutzschicht bedeckt ist. Die etwaige Haftvermittlerschicht und/oder Schutzschicht haben keinen oder zumindest keinen nennenswerten Einfluss auf die untersuchten Eigenschaften des Schichtsystems mit der einen Einzellage.

Alternativ kann das Schichtsystem aus mehreren Einzellagen gebildet sein, die aufeinander auf einem Substrat abgeschieden sind und bei welchem die Einzellagen jeweils Schichtdicken aufweisen, die gleich oder voneinander verschieden sein können. Auch hier kann zwischen der substratnächsten Einzellage und dem Substrat eine Haftvermittlerschicht angeordnet sein und/oder das Schichtsystem mit einer Schutzschicht bedeckt sein. Die etwaige Haftvermittlerschicht und/oder Schutzschicht haben keinen oder zumindest keinen nennenswerten Einfluss auf die untersuchten Eigenschaften des Schichtsystems mit den mehreren Einzellagen.

Optional können als Haftvermittler zwischen Substrat und Schichtsystem auch Zwischenlagen vorgesehen sein, beispielsweise ein übliches Lacksystem wie z.B. Hartlack, Primerlack, Pufferlack etc.

Falls nicht anderweitig angegeben, sollen die in dieser Offenbarung verwendeten Begriffe im Sinne der Norm DIN EN ISO 13666:2013-10 (EN ISO 13666:2012 (D/E)) und der DIN EN ISO 11664-4:2012-06 (EN ISO 11664-4:2011) des Deutschen Instituts für Normung e.V. verstanden werden.

Der Begriff sichtbares Licht, sichtbare Strahlung bzw. ein sichtbarer Wellenlängenbereich betrifft gemäß Abschnitt 4.2 der Norm DIN EN ISO 13666:2013-10 optische Strahlung, die unmittelbar eine Lichtempfindung beim Menschen hervorzurufen vermag. Sichtbare Strahlung bezieht sich allgemein auf einen Wellenlängenbereich von 400 nm bis 780 nm.

Im Rahmen dieser Offenbarung kann sich sichtbare Strahlung bevorzugt auf einen Wellenlängenbereich von 400 nm bzw. 460 nm bis 700 nm beziehen, entsprechend des Sensitivitätsmaximums des menschlichen Auges. Damit kann gleichzeitig die Designflexibilität für die Auslegung der Filtereigenschaften und Flankensteilheit erhöht werden.

Der Begriff spektraler Reflexionsgrad, Reflexionsgrad oder Reflektivität bezeichnet entsprechend Abschnitt 15.1 der Norm DIN EN ISO 13666:2013-10 das Verhältnis der spektralen Strahlungsleistung, die von dem jeweiligen Material bzw. der Oberfläche oder Beschichtung reflektiert wird, zur auftreffenden Strahlungsleistung für eine bestimmte Wellenlänge ($\lambda$).

Im vorliegenden Fall bezieht sich die Reflektivität auf die Reflektivität der gesamten Beschichtung mit ihren mehreren hoch- und niedrigbrechenden Teilschichten und nicht auf die Reflektivität einer einzelnen Teilschicht.

Nach einem ersten Aspekt der Erfindung wird ein Verfahren zum Betreiben eines Beschichtungssystems zur Herstellung von Schichtsystemen vorgeschlagen, umfassend

(i) Beschichten eines Schichtsystems in einer Beschichtungsanlage;

(ii) Bestimmen einer spektralen Ist-Messkurve des Schichtsystems in einem optischen Messsystem;

(iii) Laden eines Soll-Datensatzes mit einem Design der abgeschlossenen Beschichtung des Schichtsystems aus einer Design-Datenbank sowie der Ist-Messkurve in einen Simulationsrechner;

(iv) Bestimmen eines Ist-Datensatzes durch Anfitten einer Simulations-Soll-Messkurve an die Ist-Messkurve in dem Simulationsrechner;

(v) Bestimmen von Ist-Schichtparametern als berechnete Ist-Schichtparameter aus der Simulations-Soll-Messkurve durch Simulation des Schichtsystems mit dem Ist-Datensatz in dem Simulationsrechner;

(vi) Ausgabe des Ist-Datensatzes und der berechneten Ist-Schichtparameter zumindest an ein Entscheidungssystem in Form eines Prozessors oder als Prozess auf einem Steuerrechner des Beschichtungssystems und an eine Ablage-Datenbank;

(vii) Bereitstellen von Qualitätsanforderungs-Daten auf der Basis von Freigabe-Kriterien für Schichtsysteme aus einer Kriterien-Datenbank, welche für den Vergleich von wenigstens dem Ist-Datensatz, den berechneten Ist-Schichtparametern und den Qualitätsanforderungs-Daten herangezogen werden;

(viii) Entscheiden über eine Freigabe des Schichtsystems in dem Entscheidungssystem auf Basis eines Vergleichs von wenigstens dem Ist-Datensatz, den berechneten Ist-Schichtparametern und Qualitätsanforderungs-Daten.

Vorteilhaft ermöglicht das erfindungsgemäße Verfahren eine selbststeuernde und rückgekoppelte Betriebsweise von Beschichtungssystemen unter qualitätsrelevanten Aspekten.

Das Entscheidungssystem kann als eigener Prozessor ausgebildet sein. Das Entscheidungssystem kann jedoch beispielsweise auch nicht als eigene Hardware, sondern als ein Prozess auf dem Steuerrechner des Beschichtungssystems implementiert sein.

Die Ist-Messkurve kann durch spektrale Messung des hergestellten Schichtsystems in dem optischen Messsystem bestimmt werden.

Dadurch, dass der Ist-Datensatz des Beschichtungssystems durch Anfitten der Simulations-Soll-Messkurve an die Ist-Messkurve bestimmt wird, kann der Ist-Datensatz so die aus dem hergestellten Schichtsystem zurückgerechneten Beschichtungsparameter des Beschichtungssystems umfassen.

Die Ist-Schichtparameter werden aus der Simulations-Soll-Messkurve durch Simulation des Schichtsystems mit dem Ist-Datensatz berechnet.

Ein Soll-Datensatz des Beschichtungssystems kann in einer Design-Datenbank liegen und ein ursprüngliches Design (Beschichtungsparameter) der herzustellenden Beschichtung umfassen. Der Soll-Datensatz kann dann zumindest die der oder den jeweiligen Einzellagen zugeordneten Anlagen-Ist-Schichtdicken der einen oder mehreren Einzellagen umfassen.

Der Soll-Datensatz mit der Soll-Messkurve enthält die Zieldaten der optimalen Beschichtung. Diese Daten können neben einer spektral aufgelösten optischen Messung noch weitere Zielgrößen, wie beispielsweise im sichtbaren Spektralbereich die Farbwerte L*, C* und h* und/oder definierte berechenbare spektrale Größen wie gemittelte oder gewichtete Transmissions- und/oder Reflexionswerte in einem beliebig zu definierenden Intervall enthalten.

Des Weiteren enthält der Soll-Datensatz beschichtungsspezifische, von klein nach groß geschachtelte spektrale Intervalle. Das größtmögliche angegebene Intervall gibt den maximalen spektralen Betrachtungsbereich wieder. Die Anzahl der Intervalle ist frei wählbar. Der Soll-Datensatz enthält charakteristische spektrale Punkte, die das optische Layout der Beschichtung eindeutig fixieren.

Die Soll-Messkurve kann spektrale Zieldaten des herzustellenden Schichtsystems enthalten.

Eine Soll-Schichtdicke kann eine Ziel-Schichtdicke des herzustellenden Schichtsystems umfassen.

Ein Simulations-Ist-Datensatz umfasst wenigstens die bei einem iterativen Optimierungsverfahren bestimmte eine Simulations-Ist-Schichtdicke einer der Einzellage des Schichtsystems oder die Simulations-Ist-Schichtdicken der mehreren Einzellagen des Schichtsystems. Der Simulations-Ist-Datensatz wird für die Rückrechnung der Simulations-Soll-Messkurve zur Soll-Messkurve verwendet.

Eine Simulations-Ist-Messkurve umfasst wenigstens eine simulierte spektrale Messkurve, die eine bestmögliche Übereinstimmung mit der durchgeführten optischen Messung als Ist-Messkurve darstellt.

Durch die Simulations-Ist-Schichtdicke wird die Ist-Messkurve in der Simulations-Ist-Messkurve zumindest angenähert.

Der Simulations-Soll-Datensatz umfasst wenigstens die bei dem iterativen Optimierungsverfahren bestimmten Simulations-Soll-Schichtdicken der mehreren Einzellagen bzw. die Simulations-Soll-Schichtdicke der einen Einzellage mit der bestmöglichen Übereinstimmung mit der Soll-Messkurve mit Verrechnung über den Simulations-Soll-Datensatz. Die eingestellten einen oder mehreren Simulations-Soll-Schichtdicken dieses Datensatzes stellen die Prozessparameter für die folgende Beschichtungscharge dar.

Dafür umfasst der Simulations-Soll-Datensatz die eingestellten Berechnungsparameter des simulierten Schichtsystems für ideale Schichten und/oder ideale Prozesse, Materialeigenschaften wie ideale Brechwerte und ideale Abscheidebedingungen, sowie Anlagenparameter wie Beschichtungsgeometrie, Schichtdickenkontrolle, etc.

Die Simulations-Soll-Messkurve umfasst wenigstens eine simulierte spektrale Messkurve, die eine bestmögliche Übereinstimmung zwischen der Soll-Messkurve und der Simulations-Ist-Messkurve darstellt,

Durch die Simulations-Soll-Schichtdicke wird die Soll-Messkurve in der Simulations-Soll-Messkurve zumindest angenähert.

Der Anlagen-Datensatz umfasst wenigstens die an der Beschichtungsanlage eingestellten Ist-Schichtdicken der mehreren Einzellagen, wenn das Schichtsystem aus mehreren Einzellagen gebildet ist, bzw. die an der Beschichtungsanlage eingestellte Ist-Schichtdicke der einen Einzellage, wenn das Schichtsystem aus nur einer Einzellage gebildet ist.

Die Anlagen-Ist-Schichtdicken können die an dem Beschichtungssystem eingestellten Schichtdicken des herzustellenden Schichtsystems sein.

Korrektur-Ist-Schichtdicken können die neuen Anlagen-Ist-Schichtdicken darstellen, welche aus den finalen Simulations-Soll-Schichtdicken mit dem finalen Simulations-Soll-Datensatz bestimmt werden, um ein nächstes Schichtsystem herzustellen.

Freigabe-Kriterien können beispielsweise Normen, Schutzrechte von Patentschriften, wie Anmeldungen, Gebrauchsmuster, erteilte Patente, etc. Die Schutzrechte basieren beispielsweise auf Anspruchsmerkmalen. Anspruchsmerkmale umfassen, aus denen numerische Werte abgeleitet werden können, und können automatisch abgeprüft werden. Freigabe-Kriterien sind in einer Kriterien-Datenbank, in der beispielsweise Normen und/oder Patentschriften mit ihren numerisch darstellbaren Anspruchsmerkmalen hinterlegt sein können.

Die Freigabe-Kriterien können vorteilhaft jedoch auch andere Merkmale wie das Einhalten vorgegebener optischer Daten anhand spektral abprüfbarer Größen, Toleranzparameter, oder Abweichungen in Beschichtungsparametern umfassen.

Freigabe-Kriterien können so zumindest zulässige und/oder nicht-zulässige Schichtparameter umfassen, insbesondere woraus Anforderungen abgeleitet werden, welche für den Vergleich mit dem Ist-Datensatz und/oder den berechneten Ist-Schichtparametern und/oder der Ist-Messkurve herangezogen werden.

Qualitätsanforderungs-Daten können auf Basis der Freigabe-Kriterien definiert werden, Qualitätsanforderungs-Daten können Toleranzwerte für den Soll-Datensatz eines Schichtsystems umfassen.

Auf diese Weise lassen sich Parameter für eine Freigabe-Entscheidung hinzuziehen, die auf Grund von apparativen Gegebenheiten oder wegen zu aufwendiger Messungen nicht direkt bestimmt werden können. Damit kann eine effiziente softwarebasierte Qualitätssicherung durchgeführt werden.

Die Qualitätsanforderungs-Daten können insbesondere aus einer Kriterien-Datenbank geladen werden.

Optional kann auch ein Berechnen von Farbwerten einer Restreflexfarbe des Schichtsystems aus der Ist-Messkurve erfolgen.

Günstigerweise kann das Beschichtungssystem zur Herstellung von Schichtsystemen beispielsweise für optische Elemente eingesetzt werden. Die spektrale Messkurve umfasst in diesem Fall Messung einer spektralen Reflexionskurve über einen, insbesondere im Sichtbaren liegenden Wellenlängenbereich, die Simulations-Soll-Messkurve entspricht einer simulierten spektralen Reflexionskurve im selben Wellenlängenbereich.

Das Feld für Beschichtungen wird vermehrt durch Regularien eingeengt, welche u.a. durch Normen, aber auch durch Patente vorgegeben werden. So gibt es beispielsweise eine Vielzahl von Patentschriften, welche unterschiedliche Charakteristika im ultravioletten Spektralbereich von Beschichtungen schützen.

Sowohl während der Entwicklungsphase von neuen Beschichtungen als auch im späteren Produktlebenszyklus bei der Fertigung von Chargen dieser neuen Beschichtungen gilt es, die Konformität mit diesen Regularien zu überwachen. Eine Überwachung derselben meint nicht nur das Abprüfen und das Dokumentieren der Prüfwerte wie bisher, sondern darüber hinaus auch die Nichtfreigabe von Beschichtungen während der Entwicklungsphase bzw. von Beschichtungschargen im Fertigungsprozess bei Nicht-Konformität mit besagten Regularien.

Im Gegensatz zu bekannten Verfahren, die an üblichen Beschichtungsanlagen mit optischem in-line-, bzw. online-Monitoring zur Korrektur von optischen Schichten bereits während des Beschichtungsvorgangs arbeiten, kann das erfindungsgemäße Verfahren einen Korrekturvorschlag quasi "posthum" aus den Daten des vorherigen Beschichtungslaufs (Run n) für den nächsten Beschichtungslauf (Run n+1) extrahieren. Zusätzlich können die Dickenrelationen der einzelnen optischen Schichten zueinander beibehalten werden.

Es findet darüber hinaus keine "beliebige" Korrektur auf eine Zielkurve hin statt, sondern es erfolgt eine intelligente Korrektur, bei der bestehende Schichtdickenrelationen berücksichtigt und somit wesentliche Schichteigenschaften erhalten bleiben. Vorteilhaft können damit nicht zuletzt auch rechtliche Grundlagen wie CE-Freigaben und dergleichen erfüllt werden und erhalten bleiben.

Vorteilhaft ermöglicht das erfindungsgemäße Verfahren durch einen softwarebasierten Prozess eine solche Freigabeentscheidung. Diese Freigabeentscheidung kann automatisiert auf Basis von hinterlegten Prüfroutinen getroffen werden. Diese Prüfroutinen überprüfen die Qualitätsanforderungs-Daten auf Basis von Freigabe-Kriterien, welche beispielsweise Normen, Schutzrechte von Patentschriften, wie Anmeldungen, Gebrauchsmuster, erteilte Patente, etc. umfassen können.

Die Schutzrechte basieren beispielsweise auf Anspruchsmerkmalen. Anspruchsmerkmale, aus denen numerische Werte abgeleitet werden können, können automatisch abgeprüft werden. Diese softwarebasierte Qualitätssicherung umfasst eine Kriterien-Datenbank, in der beispielsweise Normen und/oder Patentschriften mit ihren numerisch darstellbaren Anspruchsmerkmalen hinterlegt sein können.

Die Freigabe-Kriterien können vorteilhaft jedoch auch andere Merkmale wie das Einhalten vorgegebener optischer Daten anhand spektral abprüfbarer Größen, Toleranzparameter, oder Abweichungen in Beschichtungsparametern umfassen.

Ein fertiggestelltes Schichtsystem, dessen Schichtaufbau bekannt ist, kann auf Konformität mit den in der Kriterien-Datenbank enthaltenen Merkmalen geprüft werden. Um auf Merkmale prüfen zu können, die sich nicht aus Messungen, wie beispielsweise Reflexionsmessungen an dem Schichtsystem, ableiten lassen, oder deren Daten nicht zur Verfügung stehen, kann eine softwarebasierte Nachstellung der Messung erfolgen. Die softwarebasierte Qualitätssicherung beinhaltet diesen Simulationsschritt.

Durch einen Abgleich von Simulation und vorhandenen Messungen kann die Aussagezuverlässigkeit sichergestellt werden.

Nach einer günstigen Ausgestaltung kann das Verfahren weiterhin wenigstens die Schritte umfassen (i) Berechnen von Farbwerten einer Restreflexfarbe des Schichtsystems aus der Ist-Messkurve; (ii) Ablegen der Ist-Messkurve und der berechneten Farbwerte in einer Ablage-Datenbank; (iii) Laden eines Soll-Datensatzes mit einem Design der abgeschlossenen Beschichtung des Schichtsystems aus einer Design-Datenbank sowie der Ist-Messkurve in einen Simulationsrechner; (iv) Bestimmen des Ist-Datensatzes durch Anfitten einer Simulations-Soll-Messkurve an die Ist-Messkurve in dem Simulationsrechner; (v) Ausgabe des Ist-Datensatzes und der berechneten Ist-Schichtparameter an das Entscheidungssystem und an die Ablage-Datenbank; (vi) Laden von Freigabe-Kriterien für Schichtsysteme aus einer Kriterien-Datenbank, welche für den Vergleich von wenigstens dem Ist-Datensatz (Dat_ist), den berechneten Ist-Schichtparametern (96) und den Qualitätsanforderungs-Daten herangezogen werden; (vii) Dokumentieren der Entscheidung über die Freigabe in der Ablage-Datenbank.

Das Design kann beispielsweise zumindest umfassen: ein erstes Material für hochbrechende erste Einzellagen und ein zweites Material für niedrigbrechende zweite Einzellagen, Anzahl gewünschter Schichtpakete mit den Einzellagen, Startwerte der Dicke der Einzellagen.

Gemäß einer vorteilhaften Ausgestaltung des erfindungsgemäßen Verfahrens können die Freigabe-Kriterien zumindest zulässige und/oder nicht-zulässige Schichtparameter umfassen, insbesondere woraus Anforderungen abgeleitet werden, welche für den Vergleich mit dem Ist-Datensatz und/oder den berechneten Ist-Schichtparametern und/oder der Ist-Messkurve herangezogen werden.

Auf diese Weise können regulative oder normative Kriterien in den Freigabeprozess mit einbezogen werden. Insbesondere können solche Kriterien herangezogen werden, deren Vorgaben nicht aus anlagerelevanten Parametern abgeleitet werden können.

Gemäß einer vorteilhaften Ausgestaltung des erfindungsgemäßen Verfahrens können die Qualitätsanforderungs-Daten Toleranzwerte für den Soll-Datensatz eines Schichtsystems umfassen. Dadurch ist es möglich, Beschichtungschargen mit gleichbleibenden optischen Messwerten herzustellen, bzw. bei Verändern von Anlageparametern entsprechende Korrekturen frühzeitig vorzunehmen.

Gemäß einer vorteilhaften Ausgestaltung des erfindungsgemäßen Verfahrens kann das Entscheiden über eine Freigabe des Schichtsystems in dem Entscheidungssystem eine automatische, softwarebasierte Freigabe-Entscheidung, insbesondere unter Verwenden eines Verfahrens der Künstlichen Intelligenz, umfassen. Vorteilhaft ermöglicht das erfindungsgemäße Verfahren durch einen softwarebasierten Prozess eine Freigabeentscheidungen mit einem hohen Automatisierungsgrad. Die Freigabeentscheidungen können automatisiert auf Basis von hinterlegten Prüfroutinen getroffen werden. Die Prüfroutinen können beispielsweise wissensbasiert auf Grund von sich laufend verändernden Kriterien-Datenbanken sich automatisch anpassen und weiterentwickeln.

Gemäß einer vorteilhaften Ausgestaltung des erfindungsgemäßen Verfahrens kann das Entscheiden über ein Beschichten eines Schichtsystems in einer Beschichtungsanlage auf Basis eines Vergleichs von wenigstens dem Soll-Datensatz und Freigabe-Kriterien aus der Kriterien-Datenbank erfolgen.

Frühzeitig kann schon im Design-Prozess während der Entwicklung eine solche Freigabe-Entscheidung herbeigeführt werden, wodurch sich die Kosten einer Produktion, welche dann hinterher möglicherweise nicht verwertet werden kann, einsparen lassen.

Gemäß einer vorteilhaften Ausgestaltung des erfindungsgemäßen Verfahrens können die berechneten Ist-Schichtparameter Reflexionswerte in Wellenlängenbereichen außerhalb der Ist-Messkurve, insbesondere im UV-Wellenlängenbereich, und/oder Reflexionswerte unter unterschiedlichen Einfallswinkeln umfassen. Eine solche Vorgehensweise basiert auf abgeleiteten Größen für die Qualitätsanforderungs-Daten auf Basis der Freigabe-Kriterien.

Auf diese Weise lassen sich Parameter für eine Freigabe-Entscheidung hinzuziehen, die auf Grund von apparativen Gegebenheiten oder wegen zu aufwendiger Messungen nicht direkt bestimmt werden können. Damit kann eine effiziente softwarebasierte Qualitätssicherung durchgeführt werden.

Gemäß einer vorteilhaften Ausgestaltung des erfindungsgemäßen Verfahrens kann das Beschichten eines Schichtsystems in einer Beschichtungsanlage umfassen, dass ein interferometrisches Schichtsystem auf wenigstens einer Oberfläche eines Substrats abgeschieden wird.

Dabei kann das Schichtsystem einen Stapel von mindestens vier aufeinander folgenden Schichtpaketen umfassen, wobei jedes Schichtpaket ein Paar von ersten und zweiten Einzellagen umfasst, wobei die ersten Einzellagen jeweils eine erste optische Dicke und die zweiten Einzellagen jeweils eine zweite, von der ersten optischen Dicke verschiedene optische Dicke aufweisen. Dabei kann ein Brechungsindex der jeweils substratnäheren ersten Einzellagen größer als ein Brechungsindex der jeweils substratferneren zweiten Einzellagen des Stapels sein.

Insbesondere kann das interferometrische Schichtsystem als reflexminderndes oder reflexverstärkendes Schichtsystem ausgebildet sein.

Das Schichtsystem kann eine Helligkeit L*, eine Buntheit C* und einen Bunttonwinkel h einer Restreflexfarbe aufweisen, wobei der Betrag einer Änderung Δh des Bunttonwinkels h der Restreflexfarbe in einem Intervall eines Betrachtungswinkels mit den Grenzwerten von 0° und 30° bezogen auf eine Oberflächennormale auf das Schichtsystem kleiner als der Betrag einer Änderung ΔC* der Buntheit C* im Intervall des Betrachtungswinkels ist.

Dabei werden folgende Schritte ausgeführt:

- Definieren eines Schichtdesigns, umfassend zumindest ein erstes Material für hochbrechende erste Einzellagen und ein zweites Material für niedrigbrechende zweite Einzellagen, Anzahl gewünschter Schichtpakete mit den Einzellagen, Startwerte der Dicke der Einzellagen;
- Definieren von Ziel-Farbwerten, umfassend Helligkeit L*, Buntheit C* und Bunttonwinkel h zumindest an Grenzwerten für ein Intervall eines Betrachtungswinkels mit Grenzwerten von 0° und 30°; und
- Durchführen eines Optimierungsverfahrens zur Variation der Einzelschichtdicken, bis ein Optimierungsziel erreicht ist.

Vorteilhaft können die Ziel-Farbwerte an den Grenzwerten des Intervalls gleich oder ähnlich gewählt werden.

Insbesondere können maximale Abweichungen für die Bunttonwinkel unterschiedlicher Restreflexfarben vorgegeben werden.

Vorteilhaft kann das Schichtsystem vier oder fünf Schichtpakete aufweisen, Es können auch mehr als fünf Schichtpakete vorgesehen sein.

Die Buntheit kann auch als Farbsättigung bezeichnet werden. Der Bunttonwinkel kann auch als Farbwinkel bezeichnet werden.

Vorteilhaft kann durch Variation der Schichtdicken der Teilschichten ein farbstabiles Schichtsystem bereitgestellt werden, dessen Restreflexfarbe sich auch bei größerer Änderung des Betrachtungswinkels nicht oder nur geringfügig ändert.

Günstigerweise kann durch eine geeignete Kombination von Buntheit und Bunttonwinkel über einen großen Betrachtungswinkelbereich eine farbstabile Restreflexfarbe erreicht werden.

Die ersten, substratnäheren Teilschichten der Schichtpakete im Stapel können aus demselben ersten Material gebildet sein. Die zweiten, substratferneren Teilschichten können ebenso aus einem gleichen, vom ersten Material der ersten Teilschichten verschiedenen zweiten Material gebildet sind.

Dabei kann vorgesehen sein, dass im substratfernsten Schichtpaket zwischen erster und zweiter Teilschicht eine Funktionsschicht aus einem dritten Material angeordnet ist, die vergleichbare Brechungseigenschaften wie die zweite Teilschicht aufweist. Für Berechnungszwecke kann die Funktionsschicht gegebenenfalls der zweiten Teilschicht zugeordnet werden. Alternativ können die Materialien der ersten Teilschichten im Stapel variieren. Ebenso kann alternativ vorgesehen sein, dass die Materialien, aus denen die zweiten Teilschichten gebildet sind, im Stapel variieren.

Vorteilhaft kann die Buntheit am oberen Grenzwert des Betrachtungswinkels einen Wert von höchstens 16 aufweisen und/oder wobei der maximale Wert der Buntheit im Intervall des Betrachtungswinkels höchstens bei 16 liegt. Dies ermöglicht die Verwirklichung aller Reflexfarben mit hoher Farbkonstanz für einen Restreflex, nicht nur am Rand des Farbtonwinkels.

Gemäß einer vorteilhaften Ausgestaltung des erfindungsgemäßen Verfahrens kann der Bunttonwinkel h im Intervall des Betrachtungswinkels mit den Grenzwerten von 0° und 30° sich um höchstens 15° ändern, bevorzugt um höchstens 10° ändern;

und/oder kann dabei der Betrag der Änderung $\Delta h$ des Bunttonwinkels h in einem zweiten Intervall eines Betrachtungswinkels von 0° bis zu einem Grenzbetrachtungswinkel $\Theta$ mit oberen Grenzwerten zwischen mindestens 30° und höchstens 45° bezogen auf die Oberflächennormale auf das Schichtsystem kleiner als der Betrag einer Änderung $\Delta C^*$ der Buntheit $C^*$ im zweiten Intervall des Betrachtungswinkels sein und der Betrag der Buntheit $C^*$ beim Grenzbetrachtungswinkel $\Theta$ mindestens 2 sein.

Insbesondere kann dabei der Bunttonwinkel h im zweiten Intervall sich höchstens um 20° ändern, bevorzugt höchstens um 15° ändern;

und/oder kann dabei der photopische Reflexionsgrad Rv im Intervall des Betrachtungswinkels mit den Grenzwerten von 0° und 30° höchstens 1,5%, bevorzugt höchstens 1,2% sein;

und/oder kann dabei der skotopische Reflexionsgrad Rv' im Intervall des Betrachtungswinkels mit den Grenzwerten von 0° und 30° höchstens 1,5%, bevorzugt höchstens 1,2% sein.

Der photopische Reflexionsgrad berücksichtigt dabei eine spektrale Empfindlichkeit des menschlichen Auges für das Sehen bei Tag, während der skotopische Reflexionsgrad eine spektrale Empfindlichkeit des menschlichen Auges für das Sehen bei Nacht berücksichtigt.

Der Farbeindruck des Restreflexes des optischen Systems bleibt für einen Beobachter über einen großen Bereich des Betrachtungswinkels ganz oder nahezu unverändert.

Vorteilhaft ergibt sich eine farbstabile Restreflexfarbe auch bei größerer Variation des Betrachtungswinkels.

Vorteilhaft können die ersten Teilschichten aus einem hochbrechenden Material gebildet sein.

Günstigerweise können die ersten Teilschichten wenigstens aus einer oder mehreren der Verbindungen $Ta_2O_5$, $TiO_2$, $ZrO_2$, $Al_2O_3$, $Nd_2O_5$, $Pr_2O_3$, $PrTiO_3$, $La_2O_3$, $Nb_2O_5$, $Y_2O_3$, $HfO_2$, InSn-Oxid, $Si_3N_4$, MgO, $CeO_2$, ZnS und/oder deren Modifikationen, insbesondere deren andere Oxidationsstufen und/oder Mischungen derselben mit Silanen und/oder Siloxanen aufweisen.

Diese Materialien sind bekannt als Werkstoffe mit hohem klassischem Brechungsindex für den Einsatz bei optischen Elementen, wie beispielsweise zur Beschichtung von Brillengläsern.

Die höherbrechenden Teilschichten können jedoch auch $SiO_2$ oder andere niedrigerbrechende Materialien enthalten, solange der Brechungsindex der gesamten Teilschicht größer als 1,6 ist, bevorzugt mindestens 1,7, besonders bevorzugt mindestens 1,8, ganz besonders bevorzugt mindestens 1,9.

Vorteilhaft können die zweiten Teilschichten aus einem niedrigbrechenden Material gebildet sein.

Die niedrigerbrechenden Teilschichten können wenigstens eines der Materialien $MgF_2$, SiO, $SiO_2$, $SiO_2$ mit Zusätzen von Al, Silane, Siloxane in Reinform oder mit deren fluorierten Derivaten, aufweisen. Die niedrigerbrechenden Teilschichten können jedoch auch eine Mischung von $SiO_2$ und $Al_2O_3$ enthalten. Bevorzugt können die niedrigerbrechenden Teilschichten wenigstens 80 Gewichtsprozent $SiO_2$, besonders bevorzugt wenigstens 90 Gewichtsprozent $SiO_2$ enthalten.

Bevorzugt ist der Brechungsindex der niedrigbrechenden Teilschichten höchstens 1,55, bevorzugt höchstens 1,48, besonders bevorzugt höchstens 1,4.

Diese Angaben von Brechungsindizes beziehen sich auf Normalbedingungen bei einer Temperatur von 25° C sowie eine Referenzwellenlänge der verwendeten Lichtintensität von 550 nm.

Typische Beispiele für Schichtmaterialien mit unterschiedlichen Brechungsindizes sind Siliziumdioxid ($SiO_2$) mit einem Brechungsindex von 1,46, Aluminiumoxid ($Al_2O_3$) mit einem Brechungsindex von 1,7, Zirkondioxid ($ZrO_2$) mit einem Brechungsindex von 2,05, Praseodym-Titanoxid ($PrTiO_3$) mit einem Brechungsindex von 2,1, Titanoxid ($TiO_2$) und Zinksulfid (ZnS) mit jeweils einem Brechungsindex von 2,3. Diese Werte stellen mittlere Werte dar, die je nach Beschichtungsverfahren und Schichtdicke bis zu 10% variieren können.

Übliche optische Gläser weisen Brechungsindizes zwischen 1,5 und 2,0 auf. Schichtmaterialien mit Brechungsindizes kleiner als 1,5 wie $MgF_2$, $SiO_2$, werden deshalb in Kombination mit optischen Gläsern als niedrig brechende Materialien bezeichnet, Schichtmaterialien mit Brechungsindizes größer als 2,0 wie $ZrO_2$, $PrTiO_3$, $TiO_2$, ZnS werden in Kombination mit optischen Gläsern als hoch brechende Materialien bezeichnet.

Der Unterschied der Brechungsindizes zwischen den hochbrechenden und niedrigbrechenden Materialien der ersten und zweiten Teilschichten beträgt vorzugsweise je nach Beschichtungsverfahren und Schichtdicke mindestens 0,2 bis mindestens 0,5.

Die verwendeten Materialien für diese Art von Beschichtungen sind die typischen Materialien, die in der Optik mittels beispielsweise PVD-Verfahren (PVD = Physical Vapour Deposition (physikalische Gasphasenabscheidung)) oder CVD-Verfahren (CVD = Chemical Vapour Deposition (chemische Gasphasenabscheidung)) auf ein Substrat aufgebracht werden.

Nach einer günstigen Ausgestaltung des optischen Elements können zumindest die ersten Teilschichten aus einem gleichen ersten Material gebildet sind und die zweiten Teilschichten zumindest überwiegend aus einem gleichen zweiten Material gebildet sind.

Optional können die zweiten Teilschichten aus dem gleichen zweiten Material gebildet sein und lediglich im substratfernsten Schichtpaket eine Funktionsschicht zwischen der ersten Teilschicht und der zweiten Teilschicht aufweisen. Die Funktionsschicht kann niedrigbrechend sein und bedarfsweise der zweiten Teilschicht für Berechnungszwecke zugeschlagen werden.

Gemäß einer vorteilhaften Ausgestaltung des erfindungsgemäßen Verfahrens kann für das Bestimmen einer spektralen Ist-Messkurve des Schichtsystems in einem optischen Messsystem eine spektrale Reflexionsmessung an dem Schichtsystem durchgeführt werden. Aus der spektralen Reflexionsmessung lassen sich auf günstige Weise geeignete weitere Schichtparameter durch Simulationsrechnungen bestimmen.

Gemäß einer vorteilhaften Ausgestaltung des erfindungsgemäßen Verfahrens kann das Berechnen von Farbwerten einer Restreflexfarbe des Schichtsystems aus der Ist-Messkurve weiter umfassen, dass eine Helligkeit L*, eine Buntheit C* und ein Bunttonwinkel h der Restreflexfarbe aus der Ist-Messkurve bestimmt wird. Gemäß einer vorteilhaften Ausgestaltung des erfindungsgemäßen Verfahrens kann das Bestimmen eines Ist-Datensatzes durch Anfitten einer Simulations-Soll-Messkurve an die Ist-Messkurve in dem Simulationsrechner weiter umfassen

(i) Erfassen wenigstens einer spektralen Messkurve mit Ordinatenwerten und Abszissenwerten als Ist-Messkurve an dem Schichtsystem, welches aus einer oder mehreren Einzellagen mit jeweiligen an der Beschichtungsanlage für die Herstellung des Schichtsystems eingestellten Anlagen-Ist-Schichtdicken besteht, wobei die eine oder mehreren Einzellagen nach einem Soll-Datensatz der wenigstens einen Beschichtungsanlage hergestellt sind, wobei der Soll-Datensatz zumindest die der oder den jeweiligen Einzellagen zugeordneten Anlagen-Ist-Schichtdicken der einen oder mehreren Einzellagen umfasst;

(ii) Zuordnen der Ist-Messkurve des Schichtsystems nach einem Zuordnungs-Kriterium, insbesondere für signifikante spektrale Punkte der Ist-Messkurve, zu einer Soll-Messkurve eines Soll-Datensatzes mit Ordinatenwerten und Abszissenwerten, dem ein Soll-Schichtsystem, gebildet aus einer oder mehreren Einzellagen zugrunde liegt, wobei der Soll-Datensatz wenigstens eine der jeweiligen Einzellage zugeordnete bekannte Soll-Schichtdicke der einen oder mehreren Einzellagen umfasst;

(iii) Generieren einer Simulations-Ist-Messkurve nach einem iterativen Verfahren durch Variieren wenigstens von Simulations-Ist-Schichtdicken der einen oder mehreren Einzellagen in zumindest einem spektralen Intervall der Ist-Messkurve und Erhalt eines finalen Simulations-Ist-Datensatzes mit wenigstens finalen den jeweiligen Einzellagen zugeordneten Simulations-Ist-Schichtdicken, durch welche die Ist-Messkurve in der Simulations-Ist-Messkurve zumindest angenähert wird, bis für das Zuordnungskriterium ein nach einem statistischen Auswahlverfahren stabiles Ergebnis erreicht ist, wobei als Startwerte der Simulations-Ist-Schichtdicken die Soll-Schichtdicken verwendet werden;

(iv) Generieren einer Simulations-Soll-Messkurve nach einem iterativen Verfahren durch Variieren wenigstens der der jeweiligen Einzellage zugeordnete Simulations-Soll-Schichtdicke der einen oder mehreren Einzellagen in zumindest einem spektralen Intervall der Soll-Messkurve und Erhalt eines finalen Simulations-Soll-Datensatzes mit wenigstens finalen den jeweiligen Einzellagen zugeordneten Simulations-Soll-Schichtdicken, durch welche die Soll-Messkurve in der Simulations-Soll-Messkurve zumindest angenähert wird, bis für das Zuordnungskriterium ein nach einem statistischen Auswahlverfahren stabiles Ergebnis erreicht ist; wobei als Startwerte der Simulations-Soll-Schichtdicken die Simulation-Ist-Schichtdicken verwendet werden;

wobei das iterative Verfahren für ein oder mehrere spektrale Intervalle durchgeführt wird, wobei jedes folgende Intervall das vorausgegangene Intervall einschließt.

Die signifikanten Punkte der Ist-Messkurve können vorteilhaft genutzt werden, um zu der Ist-Messkurve des untersuchten Schichtsystems das passende Soll-Design des Schichtsystems zu finden und dann für eine erste Annäherung in Form einer horizontalen und/oder lateralen Verschiebung der Messkurve zu nutzen.

Der Soll-Datensatz mit der Soll-Messkurve enthält die Zieldaten der optimalen Beschichtung. Diese Daten können neben einer spektral aufgelösten optischen Messung noch weitere Zielgrößen, wie beispielsweise im sichtbaren Spektralbereich die Farbwerte L*, C* und h* und/oder definierte berechenbare spektrale Größen wie gemittelte oder gewichtete Transmissions- und/oder Reflexionswerte in einem beliebig zu definierenden Intervall enthalten. Beispiele für spektral berechenbare Größen können der visuelle Bereich wie auch der IR-A/IR-B und/oder UV-A/UV-B-Bereich sein.

Des Weiteren enthält der Soll-Datensatz beschichtungsspezifische, von klein nach groß geschachtelte spektrale Intervalle. Das größtmögliche angegebene Intervall gibt den maximalen spektralen Betrachtungsbereich wieder. Die Anzahl der Intervalle ist frei wählbar. Der Soll-Datensatz enthält charakteristische spektrale Punkte, die das optische Layout der Beschichtung eindeutig fixieren.

Die Ist-Messkurve umfasst wenigstens die Daten der durchgeführten optischen Messung. Der Anlagen-Datensatz umfasst wenigstens die an der Beschichtungsanlage eingestellten Ist-Schichtdicken der mehreren Einzellagen, wenn das Schichtsystem aus mehreren Einzellagen gebildet ist, bzw. die an der Beschichtungsanlage eingestellte Ist-Schichtdicke der einen Einzellage, wenn das Schichtsystem aus nur einer Einzellage gebildet ist.

Die Simulations-Ist-Messkurve umfasst wenigstens eine simulierte spektrale Messkurve, die eine bestmögliche Übereinstimmung mit der durchgeführten optischen Messung als Ist-Messkurve darstellt.

Der Simulations-Ist-Datensatz umfasst wenigstens die bei dem iterativen Optimierungsverfahren bestimmte eine Simulations-Ist-Schichtdicke einer der Einzellage des Schichtsystems oder die Simulations-Ist-Schichtdicken der mehreren Einzellagen des Schichtsystems.

Die Simulations-Soll-Messkurve umfasst wenigstens eine simulierte spektrale Messkurve, die eine bestmögliche Übereinstimmung zwischen der Soll-Messkurve und der Simulations-Ist-Messkurve darstellt.

Der Simulations-Soll-Datensatz umfasst wenigstens die bei dem iterativen Optimierungsverfahren bestimmten Simulations-Soll-Schichtdicken der mehreren Einzellagen bzw. die Simulations-Soll-Schichtdicke der einen Einzellage mit der bestmöglichen Übereinstimmung mit der Soll-Messkurve mit Verrechnung über den Simulations-Soll-Datensatz. Die eingestellten einen oder mehreren Simulations-Soll-Schichtdicken dieses Datensatzes stellen die Prozessparameter für die folgende Beschichtungscharge dar.

Dafür umfasst der Simulations-Soll-Datensatz die eingestellten Berechnungsparameter des simulierten Schichtsystems für ideale Schichten und/oder ideale Prozesse, Materialeigenschaften wie ideale Brechwerte und ideale Abscheidebedingungen, sowie Anlagenparameter wie Beschichtungsgeometrie, Schichtdickenkontrolle, etc.

Der Simulations-Soll-Datensatz korreliert zum einem die optischen Unterschiede zwischen der Ist-Messkurve und der Simulations-Ist-Messkurve sowie berücksichtigt dabei systembedingte Abweichungen, wie morphologische und technische Abweichungen von Beschichtungscharge zu Beschichtungscharge, sowie nicht-systembedingte Abweichungen, wie zum Beispiel Handhabungsunterschiede etc.. Zum anderen wird der Simulations-Ist-Datensatz für die Rückrechnung der Simulations-Soll-Messkurve zur Soll-Messkurve verwendet.

Das erfindungsgemäße Verfahren sieht vor, dass eine Ist-Messkurve eines Schichtsystems, welches auf der Beschichtungsanlage abgeschieden wurde, in die Simulationssoftware eines Simulationsrechners, geladen wird.

Ausgehend von den skalierten vorläufigen einen oder mehreren Schichtdicken des vorherigen Schritts startet ein Optimierungsverfahren in einem eingeschränkten spektralen Intervall. Dieses eingeschränkte spektrale Intervall ist beschichtungsindividuell und in dem zu der Soll-Messkurve zugeordneten Soll-Datensatz hinterlegt als erstes mögliches aus einer Intervall-Liste des Soll-Datensatzes.

Im Rahmen dieses Optimierungsverfahrens wird die Schichtdicke der einen Einzellage, falls das Schichtsystem aus einer Einzellage gebildet ist, bzw. werden Schichtdicken der mehreren Einzellagen, falls das Schichtsystem aus mehreren Einzellagen gebildet ist, ermittelt, welche die Ist-Messkurve mit der zugrundenliegenden Simulations-Soll-Messkurve in einer ersten Annäherung beschreiben.

Nach diesem Schritt steht ein zweiter vorläufiger Satz an einer oder mehreren Schichtdicken bereit. Falls keine Beschränkung notwendig war, ist dieser zweite Simulations-Ist-Datensatz identisch zum ersten vorläufigen Simulations-Ist-Datensatz.

Für jedes weitere spektrale Intervall aus der Intervall-Liste des Soll-Datensatzes wird jetzt das Optimierungsverfahren angewandt. Das aktuell laufende Optimierungsverfahren verwendet immer den Satz des Simulations-Ist-Datensatzes des vorherigen Optimierungsverfahrens.

Typischerweise kann ein angepasster Simplex-Algorithmus als Optimierungsverfahren verwendet werden, jedoch können andere bekannte Simulationsverfahren ebenso geeignet sein. Simulationssoftware für derartige Optimierungsverfahren ist von verschiedenen Herstellern kommerziell erhältlich, beispielsweise die kommerzielle Simulationssoftware "Essential MacLeod" oder andere bekannte Simulationssoftware beispielsweise für die Herstellung optischer Schichten.

Wenn alle Intervall-Iterationen durchgelaufen sind, sind die spektralen Daten der Ist-Messkurve in guter Übereinstimmung angenähert und es liegt eine erste finale Simulations-Ist-Messkurve sowie auch ein entsprechender Satz von Simulations-Ist-Schichtdicken vor. Diese beiden Parametersätze bilden den Simulations-Ist-Datensatz, der zwischengespeichert wird.

Diese Schritte werden so oft wiederholt, bis sich nach einem statistischen Auswahlverfahren ein stabiles Ergebnis ergibt. Vorzugsweise kann hierzu die gesamte Kurve betrachtet werden, insbesondere z.B. hinsichtlich Chi-Quadrat Abweichungen und dergleichen.

Gemäß einer vorteilhaften Ausgestaltung des erfindungsgemäßen Verfahrens kann das Bestimmen berechneter Ist-Schichtparameter durch Simulation des Schichtsystems mit dem Ist-Datensatz weiter umfassen: das Bereitstellen des finalen Simulations-Soll-Datensatzes für die wenigstens eine Beschichtungsanlage als neuer Anlagen-Datensatz zur Abscheidung eines weiteren Schichtsystems mit wenigstens einen oder mehreren Korrektur-Ist-Schichtdicken für die Bestimmung von neuen Anlagen-Ist-Schichtdicken, welche aus den finalen Simulations-Soll-Schichtdicken mit dem finalen Simulations-Soll-Datensatz bestimmt werden.

Wenn die spektralen Daten der Ist-Messkurve in bestmöglicher Übereinstimmung angenähert sind, kann mit den einen oder mehreren Simulations-Ist-Schichtdicken der finale Simulations-Soll-Datensatz generiert werden. Mit dem neuen Anlagen-Datensatz können dann weitere Schichtsysteme auf der Beschichtungsanlage hergestellt werden, welche dem ursprünglich gewünschten Soll-Datensatz in besserer Weise entsprechen.

Nach einem weiteren, insbesondere eigenständigen Aspekt der Erfindung wird ein Beschichtungssystem vorgeschlagen zur Herstellung von Schichtsystemen mit einem Verfahren wie vorstehend beschrieben, umfassend wenigstens eine Beschichtungsanlage zum Beschichten eines Substrats mit einem Schichtsystem für ein optisches Element; einen Steuerrechner zum Steuern der Beschichtungsanlage und zur Kommunikation mit einem Simulationsrechner; ein optisches Messgerät zum Bestimmen einer spektral aufgelösten Ist-Messkurve des Schichtsystems; einen Simulationsrechner, auf dem eine Simulationssoftware zur optischen Berechnung und Optimierung des Schichtsystems installiert ist; eine Design-Datenbank zur Speicherung von Soll-Datensätzen; eine Ablage-Datenbank zur Speicherung von Ist-Messkurven, Ist-Datensätzen, berechneten Ist-Schichtparametern und Freigabe-Entscheidungen; eine Kriterien-Datenbank zur Speicherung von Freigabe-Kriterien, und ein Entscheidungssystem zur Freigabe von Schichtsystemen.

Das Beschichtungssystem umfasst auf diese Weise alle nötigen Komponenten, welche für ein effektives Betreiben der Beschichtungsanlage gemäß dem erfindungsgemäßen Verfahren wie oben beschrieben benötigt werden. Dadurch lässt sich eine Beschichtungsanlage zur Herstellung eines Schichtsystems effektiver und schneller betreiben. So ergibt sich erhebliches Einsparungspotential beim Betrieb der Beschichtungsanlage.

Die Beschichtungsanlage umfasst beispielsweise eine Vakuumkammer mit zugeordneten Aggregaten zur Beschichtung von Substraten wie verschiedene Beschichtungsquellen, Blenden, Glashalter, Pumpen, etc.

Vorteilhaft kann das Beschichtungssystem unter Verwendung des Verfahrens nach dem ersten Aspekt der Erfindung selbststeuernd und rückgekoppelt betrieben werden.

Der Steuerrechner der Beschichtungsanlage steuert den Beschichtungsprozess auf der Beschichtungsanlage und übernimmt die Kommunikation mit der Beschichtungsanlage. Zum automatischen Datenaustausch kann dieser Rechner zumindest über eine Netzwerkverbindung verfügen.

In dem optischen Messgerät kann ein spektral aufgelöstes Messsignal aufgezeichnet werden, welches das optische Element bestehend aus dem optischen Substrat und dem aufgebrachten Schichtsystem wiedergibt. Diese sogenannte Ist-Messkurve kann als ein zweidimensionaler Datensatz, bestehend aus Datentupeln, zum Beispiel als Wellenlänge in Nanometer, Reflektivität in %, zur Verfügung gestellt werden. Diese Daten werden als "spektrale Daten" bezeichnet.

Auf dem Simulationsrechner ist die Simulationssoftware installiert.

Die Simulationssoftware ist ein Computerprogramm, welches zumindest den von dem optischen Messgerät erzeugten Datensatz einlesen kann. Weiter kann die Simulationssoftware Datensätze der Beschichtungsanlage einlesen und ausgeben.

Die Software arbeitet mit Eingabe von der Design-Datenbank und liest beispielsweise Soll-Datensätze aus der Design-Datenbank aus, speichert neu berechnete Simulations-Datensätze in der Ablage-Datenbank ab. Weiter implementiert die Software mindestens einen beliebigen Optimierungs-/Fitalgorithmus, wie er in handelsüblichen Simulationsprogrammen zu finden ist, beispielsweise in "Essential MacLeod".

In der Ablage-Datenbank sind die gewonnenen Simulations-Soll-Datensätze für jede Beschichtungsanlage und für jeden Beschichtungsprozess abgespeichert und können zu einem späteren Zeitpunkt wiederausgelesen werden. Zusätzlich enthält die Datenbank für alle hinterlegten Beschichtungsprozesse die zugehörigen Soll-Datensätze.

In der Kriterien-Datenbank sind die relevanten Freigabe-Kriterien nach den jeweils neuesten Regularien, Recherchen von Patentdatenbanken, Festlegungen nach Entwicklungs- und Vertriebsgesichtspunkten und dergleichen gespeichert.

Das Entscheidungssystem, welches als eigener Prozessor ausgebildet sein kann, trifft Entscheidungen über eine Freigabe des Schichtsystems auf Basis eines Vergleichs von wenigstens dem Ist-Datensatz, den berechneten Ist-Schichtparametern und den Qualitätsanforderungs-Daten und dokumentiert die Entscheidung in der Ablage-Datenbank.

Das Entscheidungssystem kann jedoch beispielsweise auch nicht als eigene Hardware, sondern als ein Prozess auf dem Steuerrechner des Beschichtungssystems implementiert sein.

Nach einem weiteren, insbesondere eigenständigen Aspekt der Erfindung wird ein Computer-Programm-Produkt vorgeschlagen für ein Verfahren zum selbststeuernden und rückgekoppelten Betreiben eines Beschichtungssystems zur Herstellung von Schichtsystemen, wobei das Computer-Programm-Produkt wenigstens ein computerlesbares Speichermedium umfasst, welches Programmbefehle umfasst, die auf einem Computersystem ausführbar sind und das Computersystem dazu veranlassen, ein Verfahren auszuführen, umfassend (i) Beschichten eines Schichtsystems in einer Beschichtungsanlage; (ii) Bestimmen einer spektralen Ist-Messkurve des Schichtsystems in einem optischen Messsystem; (iii) Laden eines Soll-Datensatzes mit einem Design der abgeschlossenen Beschichtung des Schichtsystems aus einer Design-Datenbank sowie der Ist-Messkurve in einen Simulationsrechner sowie der Ist-Messkurve in einen Simulationsrechner; (iv) Bestimmen eines Ist-Datensatzes durch Anfitten einer Simulations-Soll-Messkurve an die Ist-Messkurve in dem Simulationsrechner; (v) Bestimmen von Ist-Schichtparametern als berechnete Ist-Schichtparameter aus der Simulations-Soll-Messkurve durch Simulation des Schichtsystems mit dem Ist-Datensatz; (vi) Ausgabe des Ist-Datensatzes und der berechneten Ist-Schichtparameter zumindest an ein Entscheidungssystem in Form eines Prozessors oder als Prozess auf einem Steuerrechner des Beschichtungssystems und an eine Ablage-Datenbank;

(vii) Bereitstellen von Qualitätsanforderungs-Daten auf der Basis von Freigabe-Kriterien für Schichtsysteme aus einer Kriterien-Datenbank, welche für den Vergleich von wenigstens dem Ist-Datensatz, den berechneten Ist-Schichtparametern und den Qualitätsanforderungs-Daten herangezogen werden;
(viii) Entscheiden über eine Freigabe des Schichtsystems in dem Entscheidungssystem auf Basis eines Vergleichs von wenigstens dem Ist-Datensatz, den berechneten Ist-Schichtparametern und den Qualitätsanforderungs-Daten.

Die Qualitätsanforderungs-Daten können insbesondere aus einer Kriterien-Datenbank geladen werden.

Optional kann auch ein Berechnen von Farbwerten einer Restreflexfarbe des Schichtsystems aus der Ist-Messkurve erfolgen.

Außerdem können berechnete Reflexionskurven, insbesondere winkelabhängige Reflexionskurven generiert und zur Entscheidung herangezogen werden. Die berechneten Ist-Schichtparameter können dabei Reflexionswerte in Wellenlängenbereichen außerhalb der Ist-Messkurve, insbesondere im UV-Wellenlängenbereich, und/oder Reflexionswerte unter unterschiedlichen Einfallswinkeln umfassen. Eine solche Vorgehensweise basiert auf abgeleiteten Größen für die Qualitätsanforderungs-Daten auf Basis der Freigabe-Kriterien. Auf diese Weise lassen sich Parameter für eine Freigabe-Entscheidung hinzuziehen, die auf Grund von apparativen Gegebenheiten oder wegen zu aufwendiger Messungen nicht direkt bestimmt werden können.

Das Computer-Programm-Produkt kann die Software zum Betreiben eines Beschichtungssystems zur Herstellung von Schichtsystemen in modularer Weise zur Verfügung stellen und für unterschiedlichste Datenverarbeitungssysteme zugänglich machen. Dabei kann das Computer-Programm-Produkt als Prozessrezeptprogramm, gekoppelt mit einem Steuerprogramm der Beschichtungsanlage vorteilhaft genutzt werden.

Vorteilhaft kann mittels des Computer-Programm-Produkts unter Verwendung des Verfahrens nach dem ersten Aspekt der Erfindung ein Beschichtungssystem oder ein System von Beschichtungsanlagen selbststeuernd und rückgekoppelt betrieben werden.

Nach einem weiteren, insbesondere eigenständigen Aspekt der Erfindung wird ein Datenverarbeitungssystem zur Ausführung eines Datenverarbeitungsprogramms vorgeschlagen, welches computerlesbare Programmbefehle umfasst, um ein Verfahren zum Betreiben wenigstens eines Beschichtungssystems zur Herstellung von Schichtsystemen, insbesondere wie vorstehend beschrieben, auszuführen.

Das Datenverarbeitungssystem kann in günstiger Weise den Simulationsrechner sowie die Design-Datenbank, die Ablage-Datenbank, die Kriterien-Datenbank, optional aber auch den Steuerrechner der Beschichtungsanlage umfassen.

Vorteilhaft kann mittels des Datenverarbeitungssystems unter Verwendung des Verfahrens nach dem ersten Aspekt der Erfindung ein Beschichtungssystem oder ein System von Beschichtungsanlagen selbststeuernd und rückgekoppelt betreibbar sein.

## Zeichnung

Weitere Vorteile ergeben sich aus der folgenden Zeichnungsbeschreibung. In den Figuren sind Ausführungsbeispiele der Erfindung dargestellt. Die Figuren, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

**Es zeigen beispielhaft:**

Fig. 1 einen Ablauf des Verfahrens zum Betreiben eines Beschichtungssystems zur Herstellung von Schichtsystemen für optische Elemente nach einem Ausführungsbeispiel der Erfindung;

Fig. 2 ein Blockdiagramm eines Beschichtungssystems nach einem Ausführungsbeispiel der Erfindung;

Fig. 3 eine Tabelle mit Freigabe-Kriterien nach dem erfindungsgemäßen Verfahren;

Fig. 4 ein optisches Element mit einem Schichtsystem aus fünf Schichtpaketen auf einem Substrat nach einem Ausführungsbeispiel der Erfindung;

Fig. 5 ein Flussdiagramm zum Bestimmen eines Ist-Datensatzes durch Anfitten einer Simulations-Soll-Messkurve an die Ist-Messkurve nach dem erfindungsgemäßen Verfahren;

Fig. 6 Reflektivitätskurven eines erfindungsgemäßen Schichtsystems bei senkrechtem Lichteinfall mit einer Gegenüberstellung einer Ist-Messkurve und einer Soll-Messkurve im Wellenlängenbereich von 280 nm bis 800 nm;

Fig. 7 eine vergrößerte Darstellung der Reflektivitätskurven von Fig. 6;

Fig. 8 Reflektivitätskurven des Schichtsystems bei senkrechtem Lichteinfall mit einer Gegenüberstellung der Soll-Messkurve und einer skalierten Simulations-Soll-Messkurve;

Fig. 9 Reflektivitätskurven des Schichtsystems bei senkrechtem Lichteinfall mit einer Gegenüberstellung der Soll-Messkurve und einer in einem ersten spektralen Intervall von 380 nm bis 580 nm angefitteten Simulations-Soll-Messkurve;

Fig. 10 Reflektivitätskurven des Schichtsystems bei senkrechtem Lichteinfall mit einer Gegenüberstellung der Soll-Messkurve und einer in einem größeren spektralen Intervall von 380 nm bis 780 nm angefitteten Simulations-Soll-Messkurve; und

Fig. 11 Reflektivitätskurven des Schichtsystems bei senkrechtem Lichteinfall mit einer Gegenüberstellung der Ist-Messkurve und einer über den gesamten Wellenlängenbereich von 280 nm bis 800 nm angefitteten Simulations-Soll-Messkurve.

## Ausführungsformen der Erfindung

In den Figuren sind gleichartige oder gleichwirkende Komponenten mit gleichen Bezugszeichen beziffert. Die Figuren zeigen lediglich Beispiele und sind nicht beschränkend zu verstehen.

Im Folgenden verwendete Richtungsterminologie mit Begriffen wie "links", "rechts", "oben", "unten", "davor" "dahinter", "danach" und dergleichen dient lediglich dem besseren Verständnis der Figuren und soll in keinem Fall eine Beschränkung der Allgemeinheit darstellen. Die dargestellten Komponenten und Elemente, deren Auslegung und Verwendung können im Sinne der Überlegungen eines Fachmanns variieren und an die jeweiligen Anwendungen angepasst werden.

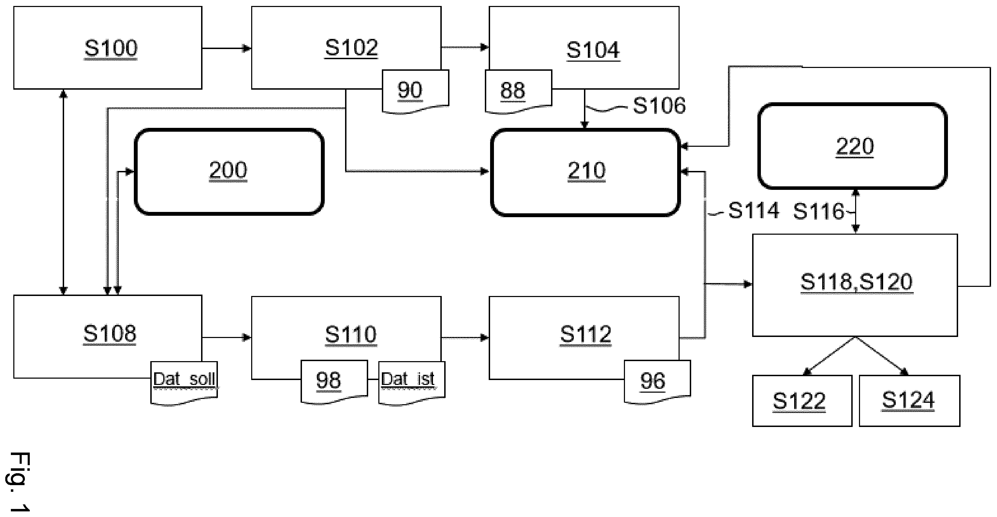

Figur 1 zeigt einen Ablauf des Verfahrens zum Betreiben eines Beschichtungssystems 100 zur Herstellung von Schichtsystemen 10 für optische Elemente 80 nach einem Ausführungsbeispiel der Erfindung.

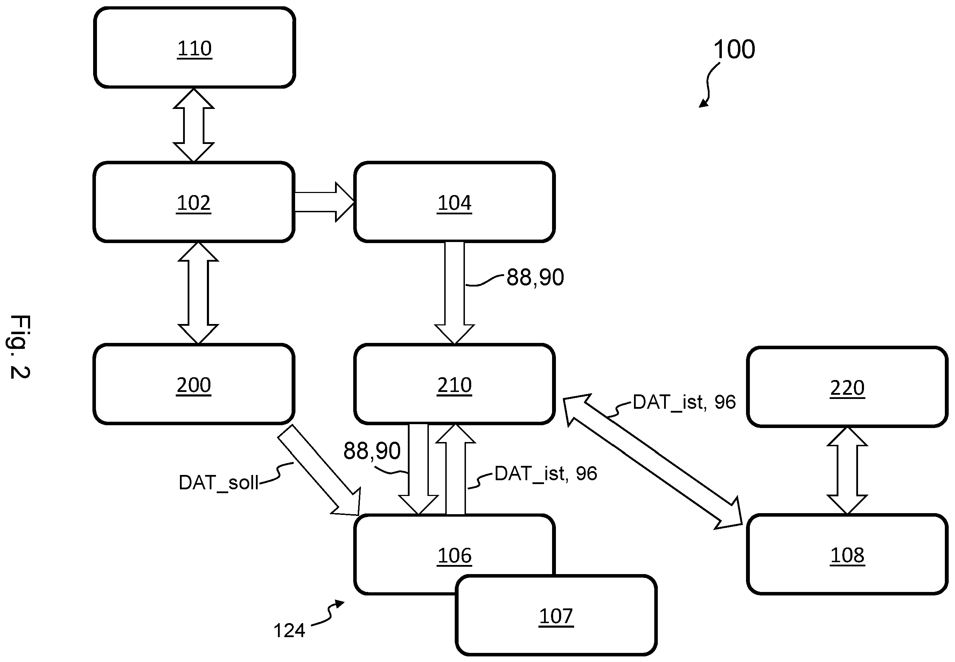

Das Verfahren umfasst in Schritt S100 das Beschichten eines Schichtsystems 10 in einer Beschichtungsanlage 102. Die Anlagenkomponenten sind in dem in Figur 2 dargestellten Blockdiagramm eines Beschichtungssystems 100 zu erkennen.

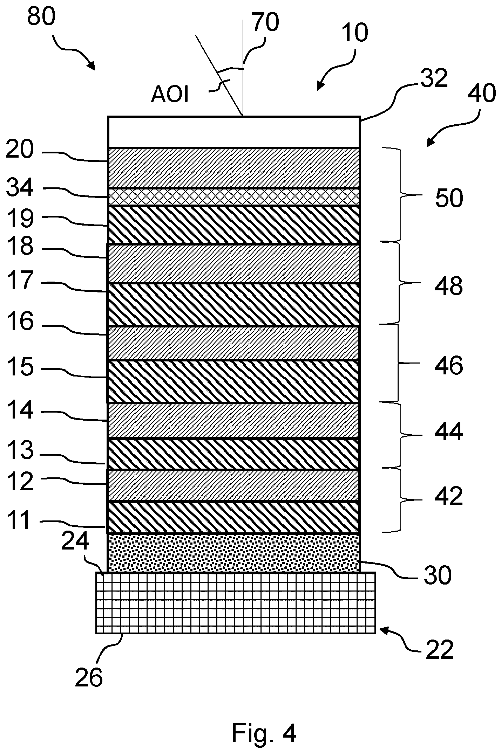

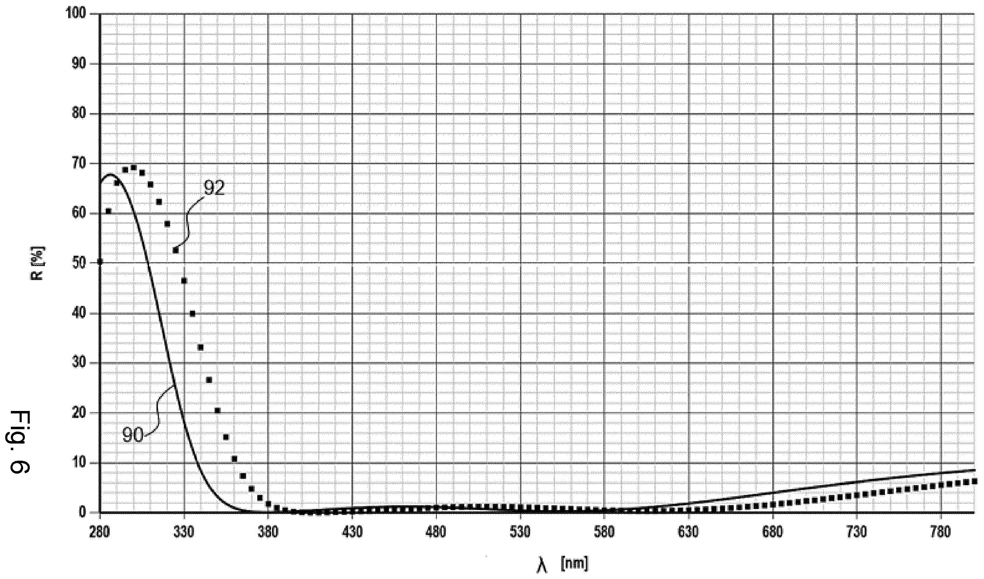

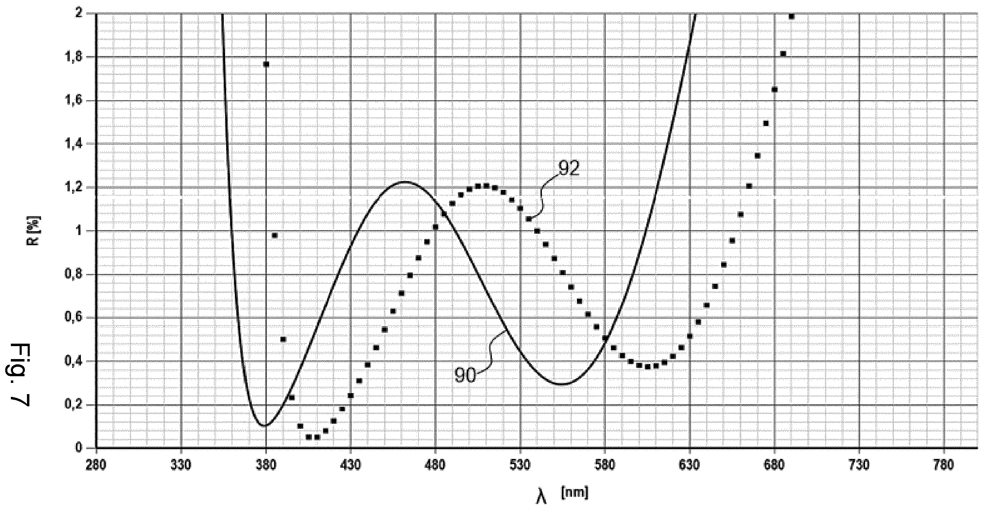

Sobald die Beschichtung abgeschlossen ist, kann in Schritt S102 eine spektrale Ist-Messkurve 90 des Schichtsystems 10 in einem optischen Messsystem 104 bestimmt werden. Dazu wird ein beschichtetes optisches Element 80 der Beschichtungsanlage entnommen und an diesem eine Messung der spektralen Reflexion zur Aufnahme einer Ist-Messkurve 90 vorgenommen. Das optische Element 80 als Schichtsystem 10 ist beispielsweise in Figur 4 spezifiziert. Eine beispielhafte Ist-Messkurve 90 ist in den Figuren 6 und 7 dargestellt.

Optional können in Schritt S104 Farbwerte 88 einer Restreflexfarbe des Schichtsystems 10 aus der Ist-Messkurve 90 bestimmt und in Schritt S106 Ist-Messkurve 90 und die berechneten Farbwerte 88 in einer Ablage-Datenbank 210 abgelegt werden. Die Farbwerte 88 der Restreflexfarbe werden nach Norm aus den Daten der spektralen Reflexion $(\lambda, R(\lambda))$ berechnet. Dabei werden beispielsweise eine Helligkeit L*, eine Buntheit C* und ein Bunttonwinkel h der Restreflexfarbe aus der Ist-Messkurve bestimmt wird.

In Schritt S108 werden sodann ein Soll-Datensatz Dat_soll des Schichtsystems 10 aus einer Design-Datenbank 200 sowie die Ist-Messkurve 90 in einen Simulationsrechner 106 geladen. Die Ist-Messkurve 90 kann als Zielkurve geladen werden. Zusätzlich wird in der Design-Datenbank 200 das Design der abgeschlossenen Beschichtung als Soll-Datensatz Dat_soll abgefragt.

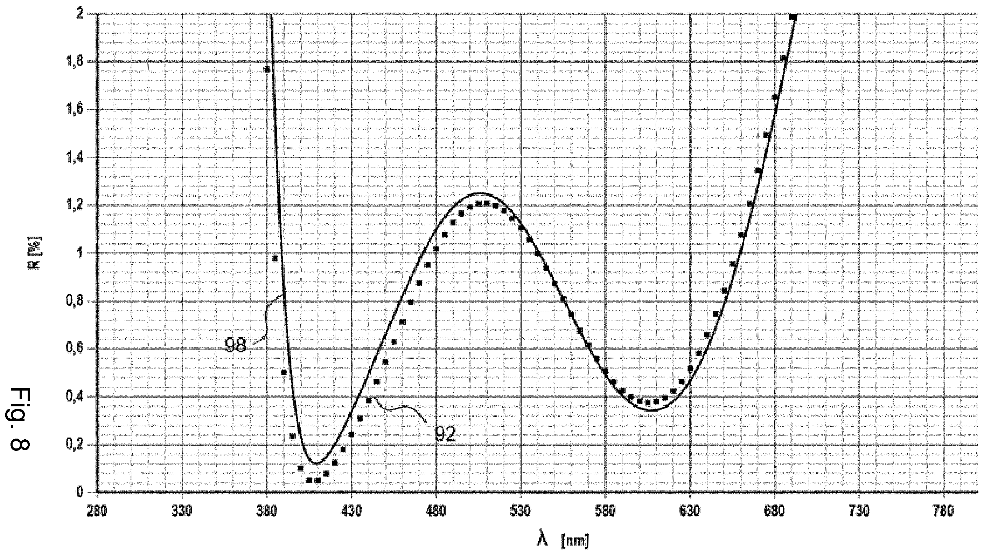

In Schritt S110 wird ein Ist-Datensatz Dat_ist durch Anfitten einer Simulations-Soll-Messkurve 98 an die Ist-Messkurve 90 in dem Simulationsrechner 106 bestimmt. Eine solche Simulations-Soll-Messkurve 98 ist beispielsweise in den Figuren 8 bis 10 dargestellt. Die physikalischen Einzelschicht-Schichtdicken des zugrundeliegenden Designs des Schichtsystems 10 werden dabei in angemessenen Grenzen variiert bis die Ist-Messkurve 90 bestmöglich getroffen wurde.

In Schritt S112 werden Ist-Schichtparameter 96 als berechnete Ist-Schichtparameter 96 aus der Simulations-Soll-Messkurve 98 durch Simulation des Schichtsystems 10 mit dem Ist-Datensatz Dat_ist bestimmt. Über die Simulation können nun weitere, aus der ursprünglichen Reflexionsmessung als Ist-Messkurve 90 nicht zugängliche Parameter wie z.B. die Reflexionskurve unter verschiedenen Einfallswinkeln, die Reflexion in spektralen Bereichen außerhalb des Messbereichs des Spektrometers, etc. gewonnen werden. Die berechneten Ist-Schichtparameter 96 können so beispielsweise Reflexionswerte in Wellenlängenbereichen außerhalb der Ist-Messkurve 90, insbesondere im UV-Wellenlängenbereich, und/oder Reflexionswerte unter unterschiedlichen Einfallswinkeln umfassen.

Anschließend werden in Schritt S114 der Ist-Datensatz Dat_ist, die berechneten Ist-Schichtparameter 96 an ein Entscheidungssystem 108 und an die Ablage-Datenbank 210 ausgegeben. Die Rohdaten der spektralen Reflexion ($\lambda$, R($\lambda$,)) sowie die daraus berechneten Farbwerte werden in der Ablage-Datenbank 210 abgespeichert.

In Schritt S116 werden Freigabe-Kriterien für Schichtsysteme 10 aus einer Kriterien-Datenbank 220 in das Entscheidungssystem 108 geladen. In Schritt S118 werden dem Entscheidungssystem 108 Qualitätsanforderungs-Daten bereitgestellt, insbesondere aus der Kriterien-Datenbank 220 in das Entscheidungssystem 108 geladen. Die Kriterien-Datenbank 220 kann Positiv- oder Negativkriterien für alle Beschichtungen umfassen.

Die Freigabe-Kriterien können zulässige und/oder nicht-zulässige Schichtparameter umfassen, insbesondere woraus Anforderungen abgeleitet werden, welche für den Vergleich mit dem Ist-Datensatz Dat_ist und/oder den berechneten Ist-Schichtparametern 96 und/oder der Ist-Messkurve 90 herangezogen werden können.

Die Qualitätsanforderungs-Daten können auch Toleranzwerte für den Soll-Datensatz Dat_soll eines Schichtsystems 10 umfassen.

Anschließend wird in Schritt S120 eine Freigabe S122, S124 des Schichtsystems 10 in dem Entscheidungssystem 108 auf Basis eines Vergleichs von wenigstens dem Ist-Datensatz Dat_ist, den berechneten Ist-Schichtparametern 96 und den Qualitätsanforderungs-Daten entschieden, S122 kann beispielsweise akzeptiert bedeuten, S124 kann abgelehnt bedeuten. Mit den berechneten Parametern kann ein Abgleich mit Zielwerten und definierten Toleranzen stattfinden. Es folgt eine automatische, softwarebasierte Freigabe-Entscheidung, ob die Beschichtungscharge den definierten Qualitätsanforderungs-Daten entspricht.

Das Entscheiden über eine Freigabe des Schichtsystems 10 in dem Entscheidungssystem 108 kann somit zweckmäßigerweise eine automatische, softwarebasierte Freigabe-Entscheidung umfassen. Insbesondere kann die Freigabe unter Verwenden eines Verfahrens der Künstlichen Intelligenz erfolgen.

Anschließend wird die Entscheidung S122, S124 in der Ablage-Datenbank 210 dokumentiert.

Alternativ kann mit dem Entscheidungssystem 108 bereits im Vorfeld vor Durchführen einer Beschichtung in der Beschichtungsanlage 102 auf Basis eines Vergleichs von wenigstens dem Soll-Datensatz Dat_soll und Freigabe-Kriterien aus der Kriterien-Datenbank 220 entschieden werden, ob das geplante Schichtsystem 10 überhaupt eine Chance hat, eine Freigabe auf Basis der bereits vorhandenen Freigabe-Kriterien zu erhalten.

Figur 2 zeigt ein Blockdiagramm eines Beschichtungssystems 100 nach einem Ausführungsbeispiel der Erfindung. Das Beschichtungssystem 100 dient zur Herstellung eines Schichtsystems 10 mit dem in Figur 1 beschriebenen Verfahren.

Das Beschichtungssystem 100 umfasst eine Beschichtungsanlage 102 zum Beschichten eines Substrats 22 mit einem Schichtsystem 10 für ein optisches Element 80, weiter einen Steuerrechner 110 zum Steuern der Beschichtungsanlage 102 und zur Kommunikation mit einem Simulationsrechner 106.

Das beschichtete optische Element 80 kann in ein optisches Messgerät 104 zum Bestimmen einer spektral aufgelösten Ist-Messkurve 90 des Schichtsystems 10 transferiert werden.

Eine Design-Datenbank 200 dient zur Speicherung von Soll-Datensätzen Dat_soll von Schichtsystemen 10.

Weiter umfasst das Beschichtungssystem 100 einen Simulationsrechner 106, auf dem eine Simulationssoftware 107 zur optischen Berechnung und Optimierung des Schichtsystems 10 installiert ist.

Auf dem Simulationsrechner 106 ist ein Computer-Programm-Produkt für ein Verfahren nach dem ersten Aspekt der Erfindung zum Betreiben wenigstens einer Beschichtungsanlage 102 zur Herstellung von Schichtsystemen 10 für optische Elemente 80 implementiert, wobei das Computer-Programm-Produkt wenigstens ein computerlesbares Speichermedium umfasst, welches Programmbefehle umfasst, die auf dem Computersystem 106 ausführbar sind und das Computersystem 106 dazu veranlassen, das Verfahren auszuführen.

Das Computer-Programm-Produkt kann als eigenständiger Aspekt der Erfindung angesehen werden, insbesondere zum Ausführen eines Verfahrens nach dem ersten Aspekt der Erfindung auf einem Simulationsrechner 106 eines Datenverarbeitungssystems 124.

Das Datenverarbeitungssystem 124, welches wenigstens den Simulationsrechner 106 und die Simulationssoftware 107 umfasst, dient zur Ausführung eines Datenverarbeitungsprogramms, welches computerlesbare Programmbefehle umfasst, um das Verfahren zum Betreiben der Beschichtungsanlage 102 zur Herstellung von Schichtsystemen 10 für optische Elemente 80, auszuführen.

Das Datenverarbeitungssystem 124 kann als eigenständiger Aspekt der Erfindung angesehen werden, insbesondere zum Ausführen eines Verfahrens nach dem ersten Aspekt der Erfindung mit einem Simulationsrechner 106.

Eine Ablage-Datenbank 202 dient zur Speicherung von Ist-Messkurven 90, Ist-Datensätzen Dat_ist, berechneten Ist-Schichtparametern 96 und Freigabe-Entscheidungen.

Schließlich ist in dem Beschichtungssystem 100 eine Kriterien-Datenbank 220 zur Speicherung von Freigabe-Kriterien vorhanden, welche von dem Entscheidungssystem 108 zur Freigabe von Schichtsystemen 10 geladen werden können. Das Entscheidungssystem 108 entscheidet über eine Freigabe des hergestellten Schichtsystems 10 auf Basis dieser Freigabe-Kriterien. In der Kriterien-Datenbank 220 können sowohl Freigabe-Kriterien als auch Qualitätsanforderungs-Daten abgelegt sein.

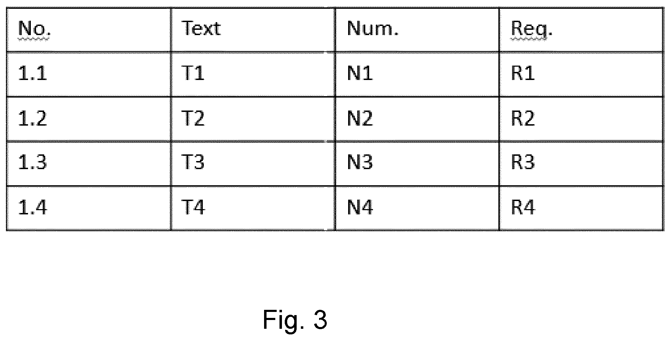

In Figur 3 ist eine Tabelle mit Freigabe-Kriterien nach dem erfindungsgemäßen Verfahren dargestellt. In der Tabelle sind einzelne Freigabe-Kriterien durchnummeriert, beispielsweise 1.1, 1.2, 1.3, 1.4. Für jedes Kriterium ist jeweils ein Langtext T1-T4 zur Erläuterung des Kriteriums, und eine numerisch abprüfbare Form N1 bis N4 sowie die Anforderung R1 bis R4, auf die sich das Kriterium bezieht, aufgelistet.

Beispielsweise können die Kriterien einzelne Anspruchsmerkmale einer Patentschrift einer optischen Anmeldung umfassen, welche in dem nachfolgenden Beispiel aufgelistet sind. Die einzelnen Merkmale in numerisch überprüfbarer Form lassen sich durch einfache Vergleichsalgorithmen automatisch abprüfen.

| Anspruchsmerkmal | Merkmal (Volltext) | Merkmal (überprüfbare Form) | Anforderung |
|---|---|---|---|
| 1.1 | Ophtalmische Linse mit Vielschichtsystem ..... | Mindestens eine niedrigreflektierende -Schicht Mindestens eine hochreflektierende Schicht | Schichtdesign |
| 1.2 | Mittlerer Reflexionsfaktor < 1,15% | $R_m < 1,15\%$ | Spektrale Reflexionskurve |
| 1.3 | Licht-Reflexionsfaktor < 1% | $R_V < 1,0\%$ | Spektrale Reflexionskurve |
| 1.4 | Beschichtung mind. 3 Schichten | Keine Indium-Zinn-Oxid (ITO) - Einzelschicht | Schichtdesign |

Die Figur 4 zeigt exemplarisch ein optisches Element 80 mit einem Schichtsystem 10 auf einem Substrat 22, beispielsweise ein Brillenglas, nach einem Ausführungsbeispiel der Erfindung. Das interferometrische Schichtsystem 10 ist auf wenigstens einer Oberfläche 24 des Substrats 22 angeordnet. Vorteilhaft ist das Schichtsystem 10 mit einem selbststeuernden und rückgekoppelten Verfahren nach dem ersten Aspekt der Erfindung herstellbar.

Als unterste Lage auf dem Substrat 22 kann das Schichtsystem 10 in üblicher Weise eine einlagige oder mehrlagige Zwischenschicht 30 aufweisen, beispielsweise zur Verbesserung der Haftung des Stapels 40 und/oder als Kratzschutz für das Substrat 22. Diese Zwischenschicht 30 kann in üblicher Weise beispielsweise aus unterstöchiometrischen niederbrechenden Metalloxiden, Chrom, Silanen oder Siloxanen bestehen Die Zwischenschicht 30 ist für die weiteren Betrachtungen der optischen Eigenschaften nicht relevant. Ebenso können als Haftvermittler zwischen Substrat und Schichtsystem auch Zwischenlagen, beispielsweise ein übliches Lacksystem wie z.B. Primerlacke und dergleichen vorgesehen sein.

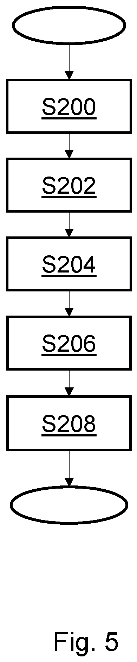

Auf der Zwischenschicht 30 sind in Figur 5 beispielsweise fünf Schichtpakete 42, 44, 46, 48, 50 eines Stapels 40 aufeinander folgend angeordnet.

Auf der Zwischenschicht 30 ist ein Stapel 40 von mindestens vier, in diesem Beispiel fünf, aufeinander folgenden Schichtpaketen 42, 44, 46, 48, 50 angeordnet, wobei jedes Schichtpaket 42, 44, 46, 48, 50 ein Paar von ersten Einzellagen 11, 13, 15, 17, 19 und zweiten Einzellagen12, 14, 16, 18, 20 umfasst.

Das substratnächste Schichtpaket 42 umfasst die substratnähere Einzellage 11 und die substratfernere Einzellage 12, das nächste Schichtpaket 44 die substratnähere Einzellage 13 und die substratfernere Einzellage 14, das darauffolgende Schichtpaket 46 die substratnähere Einzellage 15 und die substratfernere Einzellage 16, das auf dieses folgende Schichtpaket 48 die substratnähere Einzellage 17 und die substratfernere Einzellage 18 und das substratfernste Schichtpaket 50 die substratnähere Einzellage 19 und die substratfernere Einzellage 20.

Optional kann das substratfernste Schichtpaket 50 zwischen der substratnäheren Teilschicht 19 und der substratferneren Teilschicht 20 eine Funktionsschicht 34 aufweisen, welche beispielsweise zur Erhöhung der elektrischen Leitfähigkeit, zur mechanischen Spannungsegalisierung und/oder als Diffusionssperre wirken kann. Diese Funktionsschicht 34 kann aus einem niedrigbrechenden Material gebildet sein, sowie mit anderen Metalloxiden wie zum Beispiel Aluminium legiert sein. Für Berechnungszwecke und Simulationszwecke der optischen Eigenschaften kann die Funktionsschicht 34 der niedrigerbrechenden Teilschicht 20 des obersten, substratfernsten Schichtpakets 50 zugeschlagen werden oder gegebenenfalls, beispielsweise bei verhältnismäßig geringer Schichtdicke, unberücksichtigt bleiben.

In jedem Schichtpaket 42, 44, 46, 48, 50 weisen die entsprechenden ersten Einzellagen 11, 13, 15, 17, 19 jeweils eine erste optische Dicke t1 und die entsprechenden zweiten Einzellagen 12, 14, 16, 18, 20 jeweils eine zweite, von der ersten optischen Dicke t1 im jeweiligen Schichtpaket 42, 44, 46, 48, 50 verschiedene optische Dicke t2 auf.

Ein Brechungsindex n1 der jeweils substratnäheren ersten Einzellagen 11, 13, 15, 17, 19 ist größer als ein Brechungsindex n2 der jeweils substratferneren zweiten Einzellagen 12, 14, 16, 18, 20 des Stapels 40. Das Schichtsystem 10 weist eine Helligkeit L*, eine Buntheit C* und einen Bunttonwinkel h einer Restreflexfarbe auf, wobei bei der Betrag einer Änderung Δh des Bunttonwinkels h der Restreflexfarbe in einem Intervall eines Betrachtungswinkels AOI mit den Grenzwerten von 0° und 30° bezogen auf eine Oberflächennormale 70 auf das Schichtsystem 10 kleiner als der Betrag einer Änderung ΔC* der Buntheit C* im Intervall des Betrachtungswinkels AOI ist.

Betrachtet wird das Schichtsystem von einem Betrachter in einem Betrachtungswinkel AOI von 0° bis zu einem Grenzwinkel, beispielsweise 30°, gemessen von der Oberflächennormalen 70 aus.

Um das Schichtsystem 10 zu entwerfen, werden günstigerweise folgende Schritte durchgeführt:

- Definieren eines Schichtdesigns, umfassend zumindest ein erstes Material für hochbrechende erste Einzellagen 11, 13, 15, 17, 19 und ein zweites Material für niedrigbrechende zweite Einzellagen 12, 14, 16, 18, 20, Anzahl gewünschter Schichtpakete 42, 44, 46, 48, 50 mit den Einzellagen 11, 12, 13, 14, 15, 16, 17, 18, 19, 20, Startwerte der Dicke der Einzellagen 11, 12, 13, 14, 15, 16, 17, 18, 19, 20;
- Definieren von Ziel-Farbwerten, umfassend Helligkeit L*, Buntheit C* und Bunttonwinkel h zumindest an Grenzwerten für ein Intervall eines Betrachtungswinkels AOI mit Grenzwerten von 0° und 30°;
- Durchführen eines Optimierungsverfahrens zur Variation der Einzelschichtdicken d_ist_11, ..., d_ist_20, bis ein Optimierungsziel erreicht ist.

Das Substrat 22 ist beispielsweise ein Kunststoff, insbesondere ein transparenter Kunststoff für ein Brillenglas.

Der Begriff Brillenglas bezeichnet im Rahmen der vorliegenden Offenbarung insbesondere ein beschichtetes Brillenglas gemäß Abschnitt 8.1.13 der Norm DIN EN ISO 13666:2013-10, also ein Brillenglas, auf das eine oder mehrere Oberflächenbeschichtungen aufgebracht wurden, insbesondere um eine oder mehrere seiner Eigenschaften zu ändern.

Bevorzugt können solche Brillengläser insbesondere vorteilhaft eingesetzt werden als Brillen (mit und ohne Korrektur), Sonnenbrillen, Skibrillen, Arbeitsplatzbrillen, sowie Brillen in Verbindung mit kopfgetragenen Anzeigeeinrichtungen (so genannte "head-mounted displays").

Der Begriff Brillenglas kann im Rahmen der vorliegenden Offenbarung ferner Brillenglas-Halbfabrikate umfassen, insbesondere ein Brillenglasblank oder Brillenglas-Halbfertigprodukt gemäß Abschnitt 8.4.2 der Norm DIN EN ISO 13666:2013-10, also einen Linsenrohling oder Blank mit nur einer optischen fertig bearbeiteten Fläche.

Bezogen auf die Ausgestaltungen in Figur 4 kann die gegenüberliegende Oberfläche 26 des Substrats 22 optional ein weiteres, ähnliches oder identisches Schichtsystem 10, keine Beschichtung oder lediglich schützende Beschichtung aufweisen (nicht dargestellt).

Vorzugsweise ist jede der substratnäheren Einzellagen 11, 13, 15, 17, 19 aus einem identischen ersten Material gebildet. Vorzugsweise ist das erste Material ein höherbrechendes Material mit einem ersten Brechungsindex n1.

Vorzugsweise ist jede der substratfernen Einzellagen 12, 14, 16, 18, 20 aus einem identischen zweiten Material gebildet. Vorzugsweise ist das zweite Material ein niedrigbrechendes Material mit einem zweiten Brechungsindex n2. Der Brechungsindex n1 ist größer als der Brechungsindex n2, vorzugsweise ist der Unterschied der Brechungsindizes n1, n2 mindestens 0,2, vorzugsweise bis mindestens 0,5.

Die Reihenfolge der ersten Einzellagen 11, 13, 15, 17, 19 und zweiten Einzellagen 12, 14, 16, 187, 20 bleibt im Stapel 40 gleich, so dass in jedem Schichtpaket 42, 44, 46, 48, 50 die jeweilige substratnähere erste Einzellage 11, 13, 15, 17, 19 immer die höherbrechende und die jeweilige substratfernere zweite Einzellage 12, 14, 16, 18, 20 immer die niedrigbrechende der Einzellagen 11, 12, 13, 14, 15, 16, 17, 18, 19, 20 ist.

Insbesondere kann es sich bei den höherbrechenden Einzellagen 11, 13, 15, 17, 19 um Schichten aus hochbrechenden Materialien handeln und bei den niedrigerbrechenden Einzellagen 12, 14, 16, 18, 20 um Schichten aus niedrigbrechenden Materialien.

Die Schichtpakete 42, 44, 46, 48, 50 im Stapel 40 unterscheiden sich nur in ihrer jeweiligen Dicke und/oder in den Dicken der einzelnen Einzellagen 11, 12, 13, 14, 15, 16, 17, 18, 19, 20 im jeweiligen Schichtpaket 42, 44, 46, 48, 50.

Der Stapel 40 ist in an sich bekannter Weise mit einer Deckschicht 32 abgeschlossen, die beispielsweise der Pflege des Schichtsystems 10 dient. Die Deckschicht 32 wird auf die letzte optisch relevante Einzellage 20 des obersten Schichtpakets 50 des Stapels 40 aufgebracht und kann beispielsweise fluorhaltige Moleküle enthalten. Die Deckschicht 32 verleiht dem Stapel 40 üblicherweise eine verbesserte Pflegeeigenschaft, mit Eigenschaften wie eine wasserabweisende und ölabweisende Funktion bei einer Oberflächenenergie von typischerweise kleiner 15 mN/m.

Die Deckschicht 32 ist für die weiteren Betrachtungen der optischen Eigenschaften des Schichtsystems 10 nicht weiter relevant.

Die optischen Eigenschaften des Stapels 40 des Schichtsystems 10 können rechnerisch mittels an sich bekannter Berechnungsverfahren und/oder Optimierungsverfahren simuliert werden. Die Herstellung des Schichtsystems 10 erfolgt sodann mit den bestimmten Schichtdicken der einzelnen Teilschichten 60, 62 der Schichtpakete 42, 44, 46, 48, 50.

Bei der Herstellung von optischen Schichtsystemen 10 werden dessen optische Eigenschaften des Schichtsystems 10 bei der Herstellung der Teilschichten 60, 62 eingestellt. Beispielsweise kann das aus der WO 2016/110339 A1 bekannte Verfahren eingesetzt werden, das im Folgenden kurz umrissen ist. Mit dem bekannten Verfahren können verschiedene optische Effekte wie Verspiegelung oder Reflexminderung in einem Materialsystem erzielt werden, indem nur die Schichtdicken verändert werden, das verwendete Material jedoch gleich bleibt. Es sind jedoch auch andere Verfahren möglich.

Durch eine in der WO 2016/110339 A1 beschriebene Variation der Schichtpaketdicken bei gleichbleibenden Materialien lassen sich unterschiedliche Reflektivitäten, insbesondere für eine reflexmindernde Wirkung erzielen. Dies wird durch Minimierung bzw. Optimierung eines Parameters $\sigma$ erreicht. Der Parameter $\sigma$ ist wiederum eine Funktion der Schichtdicken der Einzellagen 11, 12, 13, 14, 15, 16, 17, 18, 19, 20, bzw. von Verhältnissen der optischen Dicken t1, t2 der Einzellagen 11, 12, 13, 14, 15, 16, 17, 18, 19, 20 eines jeden der vier Schichtpakete 42, 44, 46, 48 (nicht dargestellt) bzw. fünf Schichtpakete 42, 44, 46, 48, 50 nach Figur 5 im Stapel 40.

Bei einer bestimmten Wellenlänge $\lambda$ bestimmt sich die optische Dicke t einer Schicht, auch FWOT (full wave optical thickness) genannt, zu

$$t=\frac{d}{\lambda}\cdot n$$

wobei d die Schichtdicke, $\lambda$ die Auslegungswellenlänge und n den Brechungsindex der Einzellagen 11, 12, 13, 14, 15, 16, 17, 18, 19, 20 darstellt.

Eine reflexmindernde Wirkung durch den Stapel 40 kann für eine vorgebbare Reflektivität $R_m$ des Stapels 40 erreicht werden, wenn das Produkt aus Reflektivität $R_m$ und dem Parameter $\sigma$ kleiner als 1 eingestellt ist:

$$R_m\cdot\sigma<1$$

Die Reflektivität $R_m$, auch Reflexionsgrad genannt, beschreibt hierbei das Verhältnis von reflektierter zu einfallender Intensität eines Lichtstrahls als Energiegröße. Die Reflektivität $R_m$ wird zweckmäßigerweise über den Bereich des Lichts von 380 nm bis 800 nm gemittelt und auf 100 % bezogen.

Eine solche Bedingung $R_m\cdot\sigma<1$ kann für einen Optimierungsprozess des Verfahrens zur Herstellung des Schichtsystems 10 als Randbedingung angesetzt werden.

Die optischen Dicken t1, t2 der ersten und zweiten Einzellagen 11, 12, 13, 14, 15, 16, 17, 18, 19, 20 der Schichtpakete 42, 44, 46, 48, 50 werden dadurch bestimmt, dass der Parameter $\sigma$ mittels eines Optimierungsverfahrens, bevorzugt mittels Variationsrechnung, bestimmt wird.

Bevorzugt werden dabei die Dicken der jeweiligen Einzellagen 11, 12, 13, 14, 15, 16, 17, 18, 19, 20 bei fünf Schichtpaketen 42, 44, 46, 48, 50 im Stapel 40 abhängig von einem Quotienten $v_i$ (mit i=1, 2, 3, 4, 5) der ersten optischen Dicke t1 jeweils der höherbrechenden ersten Einzellagen 11, 13, 15, 17, 19 und der zweiten optischen Dicke t2 der niedrigerbrechenden zweiten Einzellagen 12, 14, 16, 18, 20 des jeweiligen Schichtpakets 42, 44, 46, 48, 50 gebildet.

In einer vorteilhaften Ausgestaltung kann bei einem Schichtsystem 10 nach Figur 4 der Parameter $\sigma$ für einen Stapel 40 mit fünf aufeinander folgenden Schichtpaketen 42, 44, 46, 48, 50 aus der Beziehung

$$\sigma = \frac{v_1}{\sum_{i=2}^{nmax} v_i}$$

bestimmt werden, wobei, i= von 2 bis nmax=5 läuft.

Die Indizes i=1, 2, 3, 4, 5 stehen für die Reihenfolge der Schichtpakete 42, 44, 46, 48, 50 auf dem Substrat 22. Entsprechend stehen $v_1$ für das substratnächste Schichtpaket 42 und $v_5$ für das substratfernste Schichtpaket 50.

Es ist bekannt, wahrnehmungsbezogene Farben im so genannten CIE-L*a*b* Farbraum (vereinfacht CIELab-Farbraum) in kartesischen Koordinaten anzugeben, wie in der DIN EN ISO 11664-4:2012-06 (EN ISO 11664-4:2011) dargelegt ist.

L* ist die CIELab-Helligkeit, a*, b* sind die CIELab-Koordinaten, C* die CIELab-Buntheit und $h_{ab}$ der CIELab-Bunttonwinkel.

Die L\*-Achse beschreibt die Helligkeit (Luminanz) der Farbe mit Werten von 0 bis 100. Die L\*-Achse steht im Nullpunkt senkrecht auf der a\*b\*-Ebene. Sie kann auch als Neutralgrauachse bezeichnet werden, da zwischen den Endpunkten Schwarz (L\*=0) und Weiß (L\*=100) alle unbunten Farben (Grautöne) enthalten sind.

Auf der a\*-Achse liegen sich Grün und Rot gegenüber, die b\*-Achse verläuft zwischen Blau und Gelb. Komplementäre Farbtöne stehen sich jeweils um 180° gegenüber, in ihrer Mitte, d.h. dem Koordinatenursprung a\*=0, b\*=0, ist Grau.

Die a\*-Achse beschreibt den Grünanteil oder Rotanteil einer Farbe, wobei negative Werte für Grün und positive Werte für Rot stehen. Die b\*-Achse beschreibt den Blauanteil oder Gelbanteil einer Farbe, wobei negative Werte für Blau und positive Werte für Gelb stehen.

Die a\*-Werte reichen von ca. -170 bis +100, die b\*-Werte von -100 bis +150, wobei die Maximalwerte nur bei mittlerer Helligkeit bestimmter Farbtöne erreicht werden. Der CIELab-Farbkörper hat im mittleren Helligkeitsbereich seine größte Ausdehnung, diese ist aber je nach Farbbereich unterschiedlich in Höhe und Größe.

Der CIELab-Bunttonwinkel $h_{ab}$ muss zwischen 0° und 90° liegen, wenn sowohl a\* und b\* positiv sind, zwischen 90° und 180°, wenn b\* positiv ist und a\* negativ, zwischen 180° und 270°, wenn sowohl a\* und b\* negativ sind und zwischen 270° und 360°, wenn b\* negativ ist und a\* positiv.

Beim CIE-L\*C\*h-Farbraum (vereinfacht CIELCh-Farbraum) sind die kartesischen Koordinaten des CIELab-Farbraums in Polarkoordinaten transformiert. Dabei werden die Zylinderkoordinaten C\* (Buntheit, relative Farbsättigung, Entfernung von der L-Achse im Zentrum) und h (Bunttonwinkel, Winkel des Farbtons im CIELab-Farbkreis) angegeben. Die CIELab-Helligkeit L\* bleibt dabei unverändert.

Der Bunttonwinkel h ergibt sich aus den a\*- und b\*-Achsen

$$h=\arctan\left(\frac{b^*}{a^*}\right)$$

Der Bunttonwinkel h steht hier für die Farbe des Restreflexes des interferometrischen Schichtsystems 10.

Die Buntheit C\* ergibt sich zu

$$C^*=\sqrt{\left(a^*\right)^2+\left(b^*\right)^2}$$

Die Buntheit C\* wird auch als Farbtiefe bezeichnet.

Um die Schichtdicken d_soll_11, ..., d_soll_20 der Einzellagen 11, 12, 13, 14, 15, 16, 17, 18, 19, 20 festzulegen, wird ein Optimierungsverfahren zur Variation der Einzellagendicken d_soll_11, ..., d_soll_20 durchgeführt, bis ein Optimierungsziel erreicht ist. Das Optimierungsverfahren variiert dann so lange die Einzellagendicken d_soll_11, ..., d_soll_20, bis das Optimierungsziel (Farbstabilität) erreicht ist.

Der Bunttonwinkel h kann sich dabei im Intervall des Betrachtungswinkels AOI mit den Grenzwerten von 0° und 30° um höchstens 15° ändern, bevorzugt um höchstens 10° ändern. Der Betrag der Änderung Δh des Bunttonwinkels h kann in einem zweiten Intervall eines Betrachtungswinkels AOI von 0° bis zu einem Grenzbetrachtungswinkel Θ mit oberen Grenzwerten zwischen mindestens 30° und höchstens 45° bezogen auf die Oberflächennormale 70 auf das Schichtsystem 10 kleiner als der Betrag einer Änderung ΔC\* der Buntheit C\* im zweiten Intervall des Betrachtungswinkels AOI sein und der Betrag der Buntheit C\* kann beim Grenzbetrachtungswinkel Θ mindestens C\*=2 sein, insbesondere kann der Bunttonwinkel h im zweiten Intervall sich höchstens um 20° ändern, bevorzugt höchstens um 15° ändern.

Der photopische Reflexionsgrad Rv im Intervall des Betrachtungswinkels AOI mit den Grenzwerten von 0° und 30° kann vorteilhaft höchstens 1,5%, bevorzugt höchstens 1,2% sein.

Der skotopische Reflexionsgrad Rv' im Intervall des Betrachtungswinkels AOI mit den Grenzwerten von 0° und 30° kann vorteilhaft höchstens als 1,5%, bevorzugt höchstens 1,2% sein.

Figur 5 zeigt ein Flussdiagramm zum Bestimmen eines Ist-Datensatzes Dat_ist durch Anfitten einer Simulations-Soll-Messkurve 98 an die Ist-Messkurve 90 nach dem erfindungsgemäßen Verfahren.

Das Verfahren wird in dem Simulationsrechner 106 durchgeführt und umfasst in Schritt S200 das Erfassen wenigstens einer spektralen Messkurve mit Ordinatenwerten und Abszissenwerten als Ist-Messkurve 90 an dem Schichtsystem 10, welches aus einer oder mehreren Einzellagen 11, 12, 13, 14, 15, 16, 17, 18, 19, 20 mit jeweiligen Anlagen-Ist-Schichtdicken d_ist_11, ..., d_ist_20 besteht. Dabei sind die eine oder mehreren Einzellagen 11, 12, 13, 14, 15, 16, 17, 18, 19, 20 nach einem Soll-Datensatz Dat_soll der Beschichtungsanlage 102 hergestellt. Der Soll-Datensatz Dat_soll umfasst zumindest die der oder den jeweiligen Einzellagen 11, 12, 13, 14, 15, 16, 17, 18, 19, 20 zugeordneten Anlagen-Ist-Schichtdicken d_ist_11, ..., d_ist_20 der einen oder mehreren Einzellagen 11, 12, 13, 14, 15, 16, 17, 18, 19, 20.

In Schritt S202 wird die Ist-Messkurve 90 des Schichtsystems 10 nach einem Zuordnungs-Kriterium zugeordnet, insbesondere für signifikante spektrale Punkte der Ist-Messkurve 90, zu einer Soll-Messkurve 92 eines Soll-Datensatzes DAT_soll mit Ordinatenwerten und Abszissenwerten, dem ein Soll-Datensatz-Schichtsystem 10_soll, gebildet aus einer oder mehreren Einzellagen 11, 12, 13, 14, 15, 16, 17, 18, 19, 20 zugrunde liegt. Dabei umfasst der Soll-Datensatz DAT_soll wenigstens eine der jeweiligen Einzellage 11, 12, 13, 14, 15, 16, 17, 18, 19, 20 zugeordnete bekannte Soll-Schichtdicke d_soll_11, ..., d_soll_20 der einen oder mehreren Einzellagen 11, 12, 13, 14, 15, 16, 17, 18, 19, 20.

In Schritt S204 wird eine Simulations-Ist-Messkurve 94 nach einem iterativen Verfahren durch Variieren wenigstens von Simulations-Ist-Schichtdicken g_ist_11, ..., g_ist_20 der einen oder mehreren Einzellagen 11, 12, 13, 14, 15, 16, 17, 18, 19, 20 in zumindest einem spektralen Intervall 82 der Ist-Messkurve 90 generiert. Daraus ergibt sich ein finaler Simulations-Ist-Datensatz DAT_ist_sim mit wenigstens finalen, den jeweiligen Einzellagen 11, 12, 13, 14, 15, 16, 17, 18, 19, 20 zugeordneten Simulations-Ist-Schichtdicken g_ist_11, ..., g_ist_20, durch welche die Ist-Messkurve 90 in der Simulations-Ist-Messkurve 94 zumindest angenähert wird. Das wird solange durchgeführt, bis für das Zuordnungskriterium ein nach einem statistischen Auswahlverfahren stabiles Ergebnis erreicht ist. Dabei werden als Startwerte der Simulations-Ist-Schichtdicken g_ist_11, ..., g_ist_20 die Soll-Schichtdicken d_soll_11, ..., d_soll_20 verwendet.

In Schritt S206 wird eine Simulations-Soll-Messkurve 98 nach einem iterativen Verfahren durch Variieren wenigstens der der jeweiligen Einzellage 11, 12, 13, 14, 15, 16, 17, 18, 19, 20 zugeordnete Simulations-Soll-Schichtdicke g_soll_11, ..., g_soll_20 der einen oder mehreren Einzellagen 11, 12, 13, 14, 15, 16, 17, 18, 19, 20 in zumindest einem spektralen Intervall 82 der Soll-Messkurve 92 generiert. Daraus ergibt sich ein finaler Simulations-Soll-Datensatz DAT_soll_sim mit wenigstens finalen, den jeweiligen Einzellagen 11, 12, 13, 14, 15, 16, 17, 18, 19, 20 zugeordneten Simulations-Soll-Schichtdicken g_soll_11, ..., g_soll_20, durch welche die Soll-Messkurve 92 in der Simulations-Soll-Messkurve 98 zumindest angenähert wird. Dies wird solange durchgeführt, bis für das Zuordnungskriterium ein nach einem statistischen Auswahlverfahren stabiles Ergebnis erreicht ist. Dabei werden als Startwerte der Simulations-Soll-Schichtdicken g_soll_11, ..., g_soll_20 die Simulation-Ist-Schichtdicken g_ist_11, ..., g_ist_20 verwendet.

Dieses iterative Verfahren wird für ein oder mehrere spektrale Intervalle 82, 84, 86 durchgeführt, wobei jedes folgende Intervall 84, 86 das vorausgegangene Intervall 82, 84 einschließt.

Das Bestimmen berechneter Ist-Schichtparameter 96 durch Simulation des Schichtsystems 10 mit dem Ist-Datensatz Dat_ist kann zweckmäßigerweise in Schritt S208 weiter das Bereitstellen des finalen Simulations-Soll-Datensatzes DAT_soll_sim für die wenigstens eine Beschichtungsanlage 102 als neuer Anlagen-Datensatz Dat_ist+1 zur Abscheidung eines weiteren Schichtsystems 10_n+1 mit wenigstens einen oder mehreren Korrektur-Ist-Schichtdicken d_korr_11, ..., d_korr_20 als neuen Anlagen-Ist-Schichtdicken d_ist_11, ..., d_ist_20 umfassen, welche aus den finalen Simulations-Soll-Schichtdicken g_soll_11, ..., g_soll_20 mit dem finalen Simulations-Soll-Datensatz DAT_soll_sim bestimmt werden.

Figur 6 zeigt Reflektivitätskurven eines erfindungsgemäßen Schichtsystems 10 mit einer Gegenüberstellung einer Ist-Messkurve 90 (durchgezogene Linie) und einer Soll-Messkurve 92 (gepunktete Linie) im Wellenlängenbereich von 280 nm bis 800 nm; Figur 7 zeigt eine vergrößerte Darstellung der Reflektivitätskurven von Figur 6. Die Soll-Messkurve 92 wurde dabei mittels Extremwert-Vergleich aus der Datenbank 106 als Soll-Messkurve 92 zur Ist-Messkurve 90 ermittelt. Man erkennt eine starke Peak-Verschiebung im niederen Wellenlängenbereich zwischen 280 nm und 380 nm und in der vergrößerten Darstellung in Figur 7 im Wellenlängenbereich von 380 nm und 680 nm.

In Figur 8 sind Reflektivitätskurven des Schichtsystems 10 mit einer Gegenüberstellung der Soll-Messkurve 92 (gepunktete Linie) und einer skalierten Simulations-Soll-Messkurve 98 (durchgezogene Linie) dargestellt. Es fand so eine horizontale Verschiebung der Simulations-Soll-Messkurve 98 statt. Das komplette Schichtsystem 10 wurde dabei skaliert, d.h. es wurde der Vektor, der alle physikalischen Schichtdicken g_soll_11, ..., g_soll_20 der das Schichtsystem 10 repräsentierenden Einzelschichten 11, 12, 13, 14, 15, 16, 17, 18, 19, 20 erhält, mit einem Skalierungsfaktor 122 multipliziert, d.h. jede Einzelschicht 11, 12, 13, 14, 15, 16, 17, 18, 19, 20 wurde um den gleichen Skalierungsfaktor 122 dicker bzw. dünner gemacht.

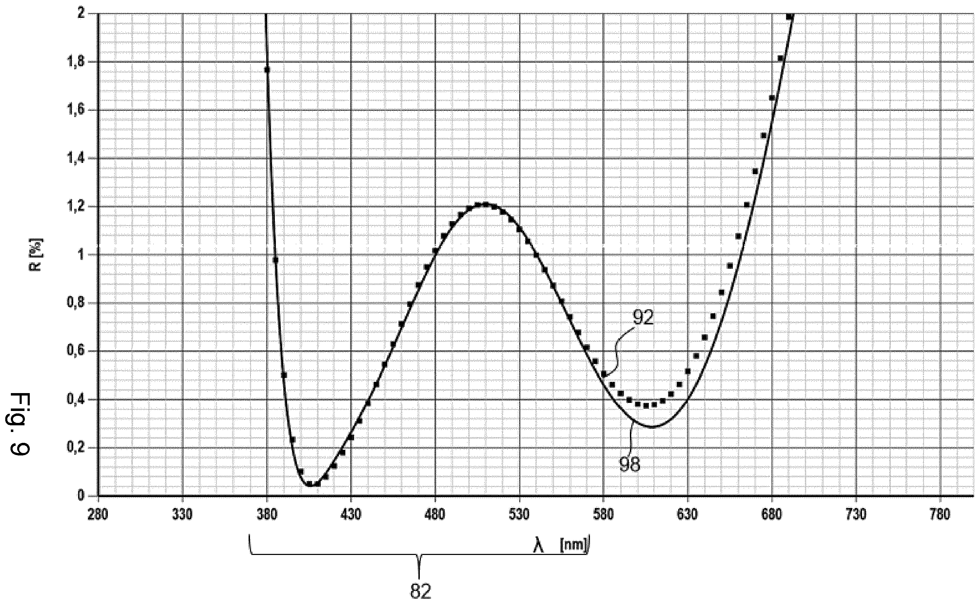

Figur 9 zeigt Reflektivitätskurven des Schichtsystems 10 mit einer Gegenüberstellung der Soll-Messkurve 92 und einer in einem ersten spektralen Intervall 82 von 380 nm bis 580 nm angefitteten Simulations-Soll-Messkurve 98. Dabei wurde für das iterative Optimierungsverfahren der Simplex-Algorithmus angewendet. Der Algorithmus wurde mit dem Optimierungsziel gestartet, die Simulations-Soll-Messkurve 98 aus dem vorherigen Schritt möglichst passgenau auf die Soll-Messkurve 92 im Intervall 380 nm bis 580 nm abzubilden durch Änderung der physikalischen Schichtdicken g_soll_11, ..., g_soll_20. Es ergibt sich eine sehr gute Annäherung der beiden Messkurven 92, 98 in dem gewählten Intervall 82.

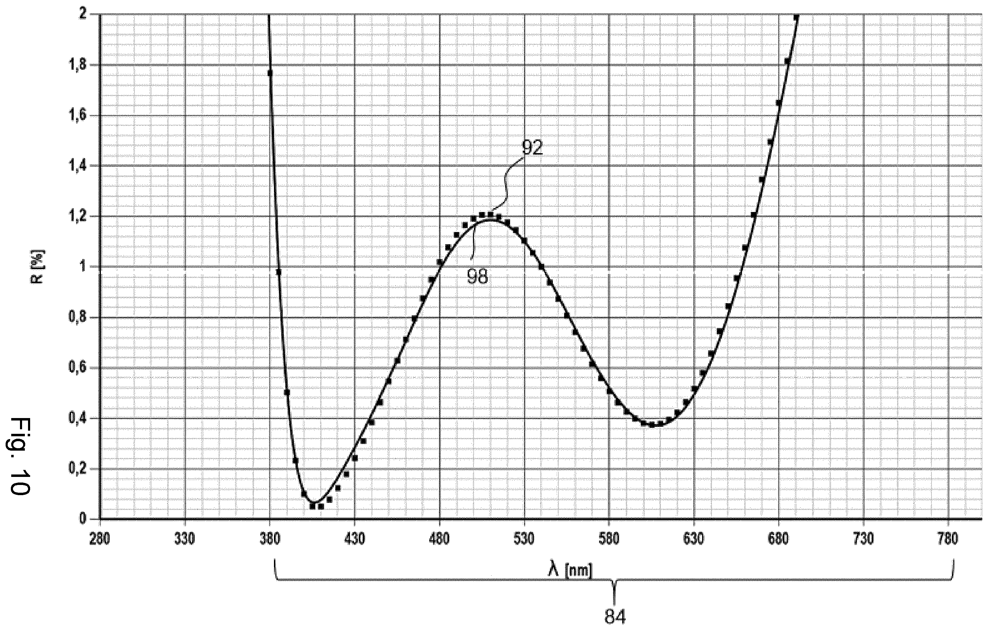

In Figur 10 sind Reflektivitätskurven des Schichtsystems 10 mit einer Gegenüberstellung der Soll-Messkurve 92 und einer in einem größeren spektralen Intervall 84 von 380 nm bis 780 nm angefitteten Simulations-Soll-Messkurve 98 dargestellt. Dieses Mal wurde eine Simplex-Optimierung in dem größeren Intervall 84 von 380 nm bis 780 nm angewandt. Es wurden keine Schichtdickenrelationen berücksichtigt. Im unteren Wellenlängenbereich um 400 nm ist die Qualität der Übereinstimmung der beiden Messkurven 92, 98 geringfügig schlechter, während sie im oberen Wellenlängenbereich von 580 nm bis 680 nm besser ist.

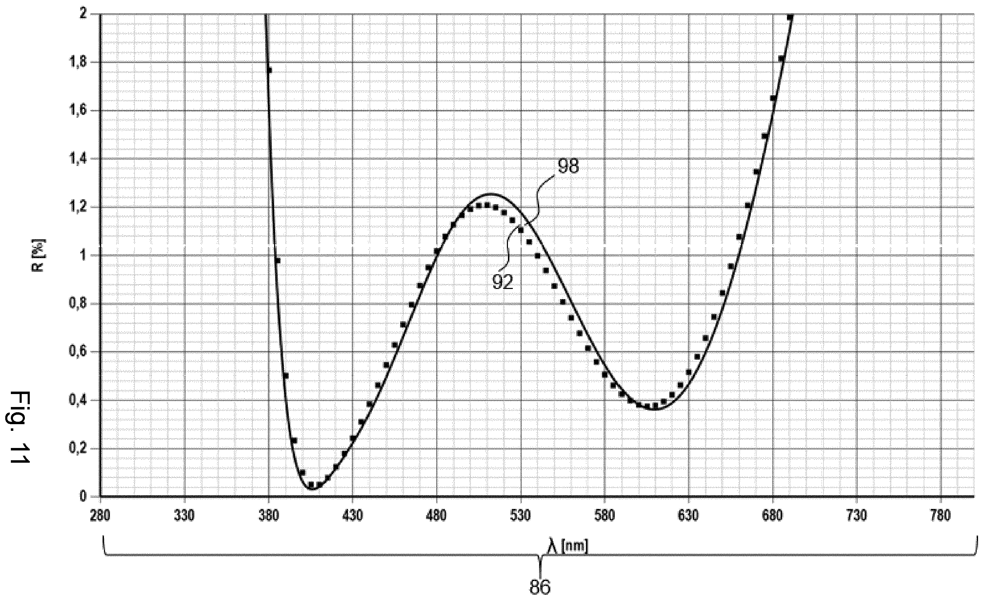

Figur 11 zeigt Reflektivitätskurven des Schichtsystems 10 mit einer Gegenüberstellung der Soll-Messkurve 92 und einer über den gesamten Wellenlängenbereich als Intervall 86 von 280 nm bis 800 nm angefitteten Simulations-Soll-Messkurve 98. Dieses Mal wurde eine Simplex-Optimierung in dem größeren Intervall 86 von 280 nm bis 800 nm angewandt. Es wurden keine Schichtdickenrelationen berücksichtigt. Die Qualität der Übereinstimmung der beiden Messkurven 92, 98 ist im mittleren Wellenlängenbereich von 480 nm bis 580 nm geringfügig schlechter geworden, jedoch im gesamten Wellenlängenbereich von 280 nm bis 800 nm im Mittel besser.

**Patentansprüche**

1. Verfahren zum selbststeuernden und rückgekoppelten Betreiben eines Beschichtungssystems (100) zur Herstellung von Schichtsystemen (10), umfassend

   (i) Beschichten (S100) eines Schichtsystems (10) in einer Beschichtungsanlage (102);
   (ii) Bestimmen (S102) einer spektralen Ist-Messkurve (90) des Schichtsystems (10) in einem optischen Messsystem (104);
   (iii) Laden (S108) eines Soll-Datensatzes (Dat_soll) mit einem Design der abgeschlossenen Beschichtung des Schichtsystems (10) aus einer Design-Datenbank (200) sowie der Ist-Messkurve (90) in einen Simulationsrechner (106);
   (iv) Bestimmen (S110) eines Ist-Datensatzes (Dat_ist) durch Anfitten einer Simulations-Soll-Messkurve (98) an die Ist-Messkurve (90) in dem Simulationsrechner (106);
   (v) Bestimmen (S112) von Ist-Schichtparametern (96) als berechnete Ist-Schichtparameter (96) aus der Simulations-Soll-Messkurve (98) durch Simulation des Schichtsystems (10) mit dem Ist-Datensatz (Dat_ist) in dem Simulationsrechner (106);
   (vi) Ausgabe (S114) des Ist-Datensatzes (Dat_ist) und der berechneten Ist-Schichtparameter (96) zumindest an ein Entscheidungssystem (108) in Form eines Prozessors oder als Prozess auf einem Steuerrechner (110) des Beschichtungssystems (100) und an eine Ablage-Datenbank (210);
   (vii) Bereitstellen (S118) von Qualitätsanforderungs-Daten auf der Basis von Freigabe-Kriterien für Schichtsysteme (10) aus einer Kriterien-Datenbank (220), welche für den Vergleich von wenigstens dem Ist-Datensatz (Dat_ist), den berechneten Ist-Schichtparametern (96) und den Qualitätsanforderungs-Daten herangezogen werden;
   (viii) Entscheiden (S120) über eine Freigabe (S122, S124) des Schichtsystems (10) in dem Entscheidungssystem (108) auf Basis eines Vergleichs von wenigstens dem Ist-Datensatz (Dat_ist), den berechneten Ist-Schichtparametern (96) und den Qualitätsanforderungs-Daten.

2. Verfahren nach Anspruch 1, weiterhin umfassend die Schritte

   (i) Berechnen (S104) von Farbwerten (88) einer Restreflexfarbe des Schichtsystems (10) aus der Ist-Messkurve (90);
   (ii) Ablegen (S106) der Ist-Messkurve (90) und der berechneten Farbwerte (88) in der Ablage-Datenbank (210);
   (iii) Dokumentieren der Entscheidung über die Freigabe (S122, S124) in der Ablage-Datenbank (210).

3. Verfahren nach Anspruch 2, wobei die Freigabe-Kriterien zumindest zulässige und/oder nicht-zulässige Schichtparameter umfassen, insbesondere woraus Anforderungen abgeleitet werden, welche für den Vergleich mit dem Ist-Datensatz (Dat_ist) und/oder den berechneten Ist-Schichtparametern (96) und/oder der Ist-Messkurve (90) herangezogen werden insbesondere
wobei die Qualitätsanforderungs-Daten Toleranzwerte für den Soll-Datensatz (Dat_soll) eines Schichtsystems (10) umfassen.

4. Verfahren nach einem der vorhergehenden Ansprüche, wobei das Entscheiden über eine Freigabe des Schichtsystems (10) in dem Entscheidungssystem (108) eine automatische, softwarebasierte Freigabe-Entscheidung, insbesondere unter Verwenden eines Verfahrens der Künstlichen Intelligenz, umfasst.

5. Verfahren nach einem der vorhergehenden Ansprüche, weiterhin umfassend Entscheiden über ein Beschichten eines Schichtsystems (10) in einer Beschichtungsanlage (102) auf Basis eines Vergleichs von wenigstens dem Soll-Datensatz (Dat_soll) und Freigabe-Kriterien aus der Kriterien-Datenbank (220).

6. Verfahren nach einem der vorhergehenden Ansprüche, wobei die berechneten Ist-Schichtparameter (96) Reflexionswerte in Wellenlängenbereichen außerhalb der Ist-Messkurve (90), insbesondere im UV-Wellenlängenbereich, und/oder Reflexionswerte unter unterschiedlichen Einfallswinkeln umfassen.

7. Verfahren nach einem der vorhergehenden Ansprüche, wobei das Beschichten eines Schichtsystems (10) in einer Beschichtungsanlage (102) umfasst, dass ein interferometrisches Schichtsystem (10) auf wenigstens einer Oberfläche (24) eines Substrats (22) abgeschieden wird,

wobei das Schichtsystem (10) einen Stapel (40) von mindestens vier aufeinander folgenden Schichtpaketen (42, 44, 46, 48, 50) umfasst, wobei jedes Schichtpaket (42, 44, 46, 48, 50) ein Paar von ersten und zweiten Einzellagen (11, 12, 13, 14, 15, 16, 17, 18, 19, 20) umfasst, wobei die ersten Einzellagen (11, 13, 15, 17, 19) jeweils eine erste optische Dicke (t1) und die zweiten Einzellagen (12, 14, 16, 18, 20) jeweils eine zweite, von der ersten optischen Dicke (t1) verschiedene optische Dicke (t2) aufweisen,
wobei ein Brechungsindex (n1) der jeweils substratnäheren ersten Einzellagen (11, 13, 15, 17, 19) größer ist als ein Brechungsindex (n2) der jeweils substratferneren zweiten Einzellagen (12, 14, 16, 18, 20) des Stapels (40),
wobei das Schichtsystem (10) eine Helligkeit (L*), eine Buntheit (C*) und einen Bunttonwinkel (h) einer Restreflexfarbe aufweist,
wobei der Betrag einer Änderung (Δh) des Bunttonwinkels (h) der Restreflexfarbe in einem Intervall eines Betrachtungswinkels (AOI) mit den Grenzwerten von 0° und 30° bezogen auf eine Oberflächennormale (70) auf das Schichtsystem (10) kleiner als der Betrag einer Änderung (ΔC*) der Buntheit (C*) im Intervall des Betrachtungswinkels (AOI) ist, wobei folgende Schritte ausgeführt werden:

- Definieren eines Schichtdesigns, umfassend zumindest ein erstes Material für hochbrechende erste Einzellagen (11, 13, 15, 17, 19) und ein zweites Material für niedrigbrechende zweite Einzellagen (12, 14, 16, 18, 20), Anzahl gewünschter Schichtpakete (42, 44, 46, 48, 50) mit den Einzellagen (11, 12, 13, 14, 15, 16, 17, 18, 19, 20), Startwerte der Dicke der Einzellagen (11, 12, 13, 14, 15, 16, 17, 18, 19, 20);
- Definieren von Ziel-Farbwerten, umfassend Helligkeit (L*), Buntheit (C*) und Bunttonwinkel (h) zumindest an Grenzwerten für ein Intervall eines Betrachtungswinkels (AOI) mit Grenzwerten von 0° und 30°;
- Durchführen eines Optimierungsverfahrens zur Variation der Einzelschichtdicken (d_ist_11, ..., d_ist_20), bis ein Optimierungsziel erreicht ist.

8. Verfahren nach Anspruch 7, wobei der Bunttonwinkel (h) im Intervall des Betrachtungswinkels (AOI) mit den Grenzwerten von 0° und 30° sich um höchstens 15° ändert, bevorzugt um höchstens 10° ändert;
und/oder

wobei der Betrag der Änderung (Δh) des Bunttonwinkels (h) in einem zweiten Intervall eines Betrachtungswinkels (AOI) von 0° bis zu einem Grenzbetrachtungswinkel (Θ) mit oberen Grenzwerten zwischen mindestens 30° und höchstens 45° bezogen auf die Oberflächennormale (70) auf das Schichtsystem (10) kleiner als der Betrag einer Änderung (ΔC*) der Buntheit (C*) im zweiten Intervall des Betrachtungswinkels (AOI) ist und der Betrag der Buntheit (C*) beim Grenzbetrachtungswinkel (Θ) mindestens 2 ist, insbesondere wobei der Bunttonwinkel (h) im zweiten Intervall sich höchstens um 20° ändert, bevorzugt höchstens um 15° ändert;
und/oder
wobei der photopische Reflexionsgrad (Rv) im Intervall des Betrachtungswinkels (AOI) mit den Grenzwerten von 0° und 30° höchstens 1,5%, bevorzugt höchstens 1,2% ist;
und/oder
wobei der skotopische Reflexionsgrad (Rv') im Intervall des Betrachtungswinkels (AOI) mit den Grenzwerten von 0° und 30° höchstens 1,5%, bevorzugt höchstens 1,2% ist.

9. Verfahren nach einem der vorhergehenden Ansprüche, wobei für das Bestimmen der spektralen Ist-Messkurve (90) des Schichtsystems (10) in einem optischen Messsystem (104) eine spektrale Reflexionsmessung an dem Schichtsystem (10) durchgeführt wird.

10. Verfahren nach einem der Ansprüche 2 bis 9, wobei das Berechnen von Farbwerten (88) einer Restreflexfarbe des Schichtsystems (10) aus der Ist-Messkurve (90) weiter umfasst, dass eine Helligkeit (L*), eine Buntheit (C*) und ein Bunttonwinkel (h) der Restreflexfarbe aus der Ist-Messkurve (90) bestimmt wird.

11. Verfahren nach einem der vorhergehenden Ansprüche, wobei das Bestimmen des Ist-Datensatzes (Dat_ist) durch Anfitten der Simulations-Soll-Messkurve (98) an die Ist-Messkurve (90) in dem Simulationsrechner (106) weiter umfasst

(i) Erfassen (S200) wenigstens einer spektralen Messkurve mit Ordinatenwerten und Abszissenwerten als Ist-Messkurve (90) an dem Schichtsystem (10), welches aus einer oder mehreren Einzellagen (11, 12, 13, 14, 15, 16, 17, 18, 19, 20) mit jeweiligen an der Beschichtungsanlage (102) für die Herstellung des Schichtsystems (10) eingestellten Anlagen-Ist-Schichtdicken (d_ist_11, ..., d_ist_20) besteht, wobei die eine oder mehreren Einzellagen (11, 12, 13, 14, 15, 16, 17, 18, 19, 20) nach dem Soll-Datensatz (DAT_soll) der wenigstens einen Beschichtungsanlage (102) hergestellt sind, wobei der Soll-Datensatz (DAT_soll) zumindest die der oder den jeweiligen Einzellagen (11, 12, 13, 14, 15, 16, 17, 18, 19, 20) zugeordneten Anlagen-Ist-Schichtdicken (d_ist_11, ..., d_ist_20) der einen oder mehreren Einzellagen (11, 12, 13, 14, 15, 16, 17, 18, 19, 20) umfasst;

(ii) Zuordnen (S202) der Ist-Messkurve (90) des Schichtsystems (10) nach einem Zuordnungs-Kriterium, insbesondere für signifikante spektrale Punkte der Ist-Messkurve (90), zu einer Soll-Messkurve (92) des Soll-Datensatzes (DAT_soll) mit Ordinatenwerten und Abszissenwerten, dem ein Soll-Schichtsystem (10_soll), gebildet aus einer oder mehreren Einzellagen (11, 12, 13, 14, 15, 16, 17, 18, 19, 20) zugrunde liegt, wobei der Soll-Datensatz (DAT_soll) wenigstens eine der jeweiligen Einzellage (11, 12, 13, 14, 15, 16, 17, 18, 19, 20) zugeordnete bekannte Soll-Schichtdicke (d_soll_11, ..., d_soll_20) der einen oder mehreren Einzellagen (11, 12, 13, 14, 15, 16, 17, 18, 19, 20) umfasst;

(iii) Generieren (S204) einer Simulations-Ist-Messkurve (94) nach einem iterativen Verfahren durch Variieren wenigstens von Simulations-Ist-Schichtdicken (g_ist_11, ..., g_ist_20) der einen oder mehreren Einzellagen (11, 12, 13, 14, 15, 16, 17, 18, 19, 20) in zumindest einem spektralen Intervall (82) der Ist-Messkurve (90) und Erhalt eines finalen Simulations-Ist-Datensatzes (DAT_ist_sim) mit wenigstens finalen, den jeweiligen Einzellagen (11, 12, 13, 14, 15, 16, 17, 18, 19, 20) zugeordneten Simulations-Ist-Schichtdicken (g_ist_11, ..., g_ist_20), durch welche die Ist-Messkurve (90) in der Simulations-Ist-Messkurve (94) zumindest angenähert wird, bis für das Zuordnungskriterium ein nach einem statistischen Auswahlverfahren stabiles Ergebnis erreicht ist, wobei als Startwerte der Simulations-Ist-Schichtdicken (g_ist_11, ..., g_ist_20) die Soll-Schichtdicken (d_soll_11, ..., d_soll_20) verwendet werden;

(iv) Generieren (S206) der Simulations-Soll-Messkurve (98) nach einem iterativen Verfahren durch Variieren wenigstens der der jeweiligen Einzellage (11, 12, 13, 14, 15, 16, 17, 18, 19, 20) zugeordnete Simulations-Soll-Schichtdicke (g_soll_11, ..., g_soll_20) der einen oder mehreren Einzellagen (11, 12, 13, 14, 15, 16, 17, 18, 19, 20) in zumindest einem spektralen Intervall (82) der Soll-Messkurve (92) und Erhalt eines finalen Simulations-Soll-Datensatzes (DAT_soll_sim) mit wenigstens finalen den jeweiligen Einzellagen (11, 12, 13, 14, 15, 16, 17, 18, 19, 20) zugeordneten Simulations-Soll-Schichtdicken (g_soll_11, ..., g_soll_20, durch welche die Soll-Messkurve (92) in der Simulations-Soll-Messkurve (98) zumindest angenähert wird, bis für das Zuordnungskriterium ein nach einem statistischen Auswahlverfahren stabiles Ergebnis erreicht ist; wobei als Startwerte der Simulations-Soll-Schichtdicken (g_soll_11, ..., g_soll_20) die Simulations-Ist-Schichtdicken (g_ist_11, ..., g_ist_20) verwendet werden;

wobei das iterative Verfahren für ein oder mehrere spektrale Intervalle (82, 84, 86) durchgeführt wird, wobei jedes folgende Intervall (84, 86) das vorausgegangene Intervall (82, 84) einschließt.

12. Verfahren nach Anspruch 11, wobei das Bestimmen berechneter Ist-Schichtparameter (96) durch Simulation des Schichtsystems (10) mit dem Ist-Datensatz (Dat_ist) weiter umfasst

Bereitstellen (S208) des finalen Simulations-Soll-Datensatzes (DAT_soll_sim) für die wenigstens eine Beschichtungsanlage (102) als neuer Anlagen-Datensatz (Dat_ist+1) zur Abscheidung eines weiteren Schichtsystems (10_n+1) mit wenigstens einen oder mehreren Korrektur-Ist-Schichtdicken (d_korr_11, ..., d_korr_20) für die Bestimmung von neuen Anlagen-Ist-Schichtdicken (d_ist_11, ..., d_ist_20), welche aus den finalen Simulations-Soll-Schichtdicken (g_soll_11, ..., g_soll_20) mit dem finalen Simulations-Soll-Datensatz (DAT_soll_sim) bestimmt werden.

13. Beschichtungssystem (100) zur selbststeuernden und rückgekoppelten Herstellung von Schichtsystemen (10), mit einem Verfahren nach wenigstens einem der vorhergehenden Ansprüche, umfassend wenigstens

- eine Beschichtungsanlage (102) zum Beschichten eines Substrats (22) mit einem Schichtsystem (10) für ein optisches Element (80),
- einen Steuerrechner (110) zum Steuern der Beschichtungsanlage (102) und zur Kommunikation mit einem Simulationsrechner (106),
- ein optisches Messgerät (104) zum Bestimmen einer spektral aufgelösten Ist-Messkurve (90) des Schichtsystems (10),
- einen Simulationsrechner (106), auf dem eine Simulationssoftware (107) zur optischen Berechnung und Optimierung des Schichtsystems (10) installiert ist,

- eine Design-Datenbank (200) zur Speicherung von Soll-Datensätzen (Dat_soll),
- eine Ablage-Datenbank (210) zur Speicherung von Ist-Messkurven (90), Ist-Datensätzen (Dat_ist), berechneten Ist-Schichtparametern (96) und Freigabe-Entscheidungen,
- eine Kriterien-Datenbank (220) zur Speicherung von Freigabe-Kriterien,
- ein Entscheidungssystem (108) zur Freigabe von Schichtsystemen (10).

14. Computer-Programm-Produkt für ein Verfahren zum selbststeuernden und rückgekoppelten Betreiben wenigstens eines Beschichtungssystems (100) zur Herstellung von Schichtsystemen (10) nach einem der Ansprüche 1 bis 12, wobei das Computer-Programm-Produkt wenigstens ein computerlesbares Speichermedium umfasst, welches Programmbefehle umfasst, die auf einem Computersystem (106) ausführbar sind und das Computersystem (106) dazu veranlassen, ein Verfahren auszuführen, insbesondere nach wenigstens Anspruch 1, umfassend

(i) Bewirken des Beschichtens (S100) eines Schichtsystems (10) in einer Beschichtungsanlage (102);
(ii) Bewirken des Bestimmens (S102) einer spektralen Ist-Messkurve (90) des Schichtsystems (10) in einem optischen Messsystem (104);
(iii) Bewirken des Ladens (S108) eines Soll-Datensatzes (Dat_soll) mit einem Design der abgeschlossenen Beschichtung des Schichtsystems (10) aus einer Design-Datenbank (200) sowie der Ist-Messkurve (90) in einen Simulationsrechner (106);
(iv) Bewirken des Bestimmens (S110) eines Ist-Datensatzes (Dat_ist) durch Anfitten einer Simulations-Soll-Messkurve (98) an die Ist-Messkurve (90) in dem Simulationsrechner (106);
(v) Bewirken des Bestimmens (S112) von Ist-Schichtparametern (96) als berechnete Ist-Schichtparameter (96) aus der Simulations-Soll-Messkurve (98) durch Simulation des Schichtsystems (10) mit dem Ist-Datensatz (Dat_ist) in dem Simulationsrechner (106);
(vi) Ausgabe (S114) des Ist-Datensatzes (Dat_ist) und der berechneten Ist-Schichtparameter (96) zumindest an ein Entscheidungssystem (108) in Form eines Prozessors oder als Prozess auf einem Steuerrechner (110) des Beschichtungssystems (100) und an eine Ablage-Datenbank (210);
(vii) Bereitstellen (S118) von Qualitätsanforderungs-Daten auf der Basis von Freigabe-Kriterien für Schichtsysteme (10) aus einer Kriterien-Datenbank (220), welche für den Vergleich von wenigstens dem Ist-Datensatz (Dat_ist), den berechneten Ist-Schichtparametern (96) und den Qualitätsanforderungs-Daten herangezogen werden;
(viii) Entscheiden (S120) über eine Freigabe (S122, S124) des Schichtsystems (10) in dem Entscheidungssystem (108) auf Basis eines Vergleichs von wenigstens dem Ist-Datensatz (Dat_ist), den berechneten Ist-Schichtparametern (96) und den Qualitätsanforderungs-Daten.

15. Datenverarbeitungssystem (124) zur Ausführung eines Datenverarbeitungsprogramms, welches ein Computer-Programm-Produkt nach Anspruch 14 umfasst, um ein Verfahren zum Betreiben wenigstens eines Beschichtungssystems (100) zur Herstellung von Schichtsystemen (10) nach wenigstens Anspruch 1, auszuführen.

**Claims**

1. Method for self-controlling and feedback-controlled operation of a coating system (100) for producing coating systems (10), comprising

(i) coating (S100) a coating system (10) in a coating plant (102);
(ii) determining (S102) an actual spectral measurement curve (90) of the coating system (10) in an optical measurement system (104);
(iii) loading (S108) a target data set (Dat_soll) with a design of the completed coating of the coating system (10) from a design database (200) and the actual measurement curve (90) into a simulation computer (106);
(iv) determining (S110) an actual data set (Dat_ist) by fitting a simulation target measurement curve (98) to the actual measurement curve (90) in the simulation computer (106);
(v) Determining (S112) actual layer parameters (96) as calculated actual layer parameters (96) from the simulation target measurement curve (98) by simulating the layer system (10) with the actual data set (Dat_ist) in the simulation computer (106);
(vi) Outputting (S114) the actual data set (Dat_ist) and the calculated actual layer parameters (96) at least to a decision system (108) in the form of a processor or as a process on a control computer (110) of the coating system (100) and to a storage database (210);
(vii) Provision (S118) of quality requirement data based on release criteria for coating systems (10) from a criteria database (220), which is used for comparison of at least the actual data set (Dat_ist), the calculated actual layer parameters (96), and the quality requirement data;

(viii) deciding (S120) on a release (S122, S124) of the layer system (10) in the decision system (108) based on a comparison of at least the actual data set (Dat_ist), the calculated actual layer parameters (96), and the quality requirement data.

2. Method according to claim 1, further comprising the steps

(i) calculating (S104) color values (88) of a residual reflex color of the layer system (10) from the actual measurement curve (90);

(ii) storing (S106) the actual measurement curve (90) and the calculated color values (88) in the storage database (210);

(iii) Documenting the decision on release (S122, S124) in the storage database (210).

3. Method according to claim 2, wherein the release criteria comprise at least permissible and/or impermissible layer parameters, in particular from which requirements are derived which are used for comparison with the actual data set (Dat_ist) and/or the calculated actual layer parameters (96) and/or the actual measurement curve (90)

in particular

wherein the quality requirement data comprise tolerance values for the target data set (Dat_soll) of a layer system (10).

4. Method according to one of the preceding claims, wherein the decision on whether to approve the layer system (10) in the decision system (108) comprises an automatic, software-based approval decision, in particular using an artificial intelligence method.

5. Method according to one of the preceding claims, further comprising deciding on coating a coating system (10) in a coating plant (102) based on a comparison of at least the target data set (Dat_soll) and release criteria from the criteria database (220).

6. Method according to one of the preceding claims, wherein the calculated actual coating parameters (96) comprise reflection values in wavelength ranges outside the actual measurement curve (90), in particular in the UV wavelength range, and/or reflection values at different angles of incidence.

7. Method according to one of the preceding claims, wherein the coating of a coating system (10) in a coating plant (102) comprises depositing an interferometric coating system (10) on at least one surface (24) of a substrate (22),

wherein the coating system (10) comprises a stack (40) of at least four consecutive coating packages (42, 44, 46, 48, 50), each coating package (42, 44, 46, 48, 50) comprising a pair of first and second individual layers (11, 12, 13, 14, 15, 16, 17, 18, 19, 20), wherein the first individual layers (11, 13, 15, 17, 19) each have a first optical thickness (t1) and the second individual layers (12, 14, 16, 18, 20) each have a second optical thickness (t2) that differs from the first optical thickness (t1),

wherein a refractive index (n1) of the respective first individual layers (11, 13, 15, 17, 19) closer to the substrate is greater than a refractive index (n2) of the respective second individual layers (12, 14, 16, 18, 20) of the stack (40) further away from the substrate,

wherein the layer system (10) has a brightness (L*), a chroma (C*) and a hue angle (h) of a residual reflection color,

wherein the amount of change (Δh) in the hue angle (h) of the residual reflection color in an interval of a viewing angle (AOI) with the limit values of 0° and 30° relative to a surface normal (70) to the layer system (10) is smaller than the amount of change (ΔC*) in the chroma (C*) in the viewing angle interval (AOI), wherein the following steps are performed:

- Defining a layer design comprising at least a first material for high-refractive first individual layers (11, 13, 15, 17, 19) and a second material for low-refractive second individual layers (12, 14, 16, 18, 20), number of desired layer packages (42, 44, 46, 48, 50) with the individual layers (11, 12, 13, 14, 15, 16, 17, 18, 19, 20), starting values for the thickness of the individual layers (11, 12, 13, 14, 15, 16, 17, 18, 19, 20);

- Defining target color values, comprising brightness (L*), chroma (C*) and hue angle (h) at least at limit values for an angle of view (AOI) interval with limit values of 0° and 30°;

- Performing an optimization process to vary the individual layer thicknesses (d_ist_11, ..., d_ist_20) until an optimization target is achieved.

8. Method according to claim 7, wherein the hue angle (h) in the viewing angle (AOI) interval with the limit values of 0° and 30° changes by a maximum of 15°, preferably by a maximum of 10°;
and/or

wherein the amount of change (Δh) of the hue angle (h) in a second interval of a viewing angle (AOI) from 0° to an upper viewing angle limit (Θ) with upper limits between at least 30° and at most 45° relative to the surface normal (70) on the layer system (10) is smaller than the amount of a change (ΔC*) in the colorfulness (C*) in the second interval of the viewing angle (AOI) and the amount of chromaticity (C*) at the limit viewing angle (Θ) is at least 2, in particular wherein the hue angle (h) in the second interval changes by at most 20°, preferably by at most 15°; and/or
wherein the photopic reflectance (Rv) in the viewing angle (AOI) interval with the limits of 0° and 30° is at most 1.5%, preferably at most 1.2%;
and/or
wherein the scotopic reflectance (Rv') in the viewing angle (AOI) interval with the limits of 0° and 30° is at most 1.5%, preferably at most 1.2%.

9. Method according to one of the preceding claims, wherein a spectral reflectance measurement is performed on the coating system (10) in an optical measuring system (104) in order to determine the actual spectral measurement curve (90) of the coating system (10).

10. Method according to one of claims 2 to 9, wherein the calculation of color values (88) of a residual reflective color of the layer system (10) from the actual measurement curve (90) further comprises determining a brightness (L*), a chroma (C*) and a hue angle (h) of the residual reflection color are determined from the actual measurement curve (90).

11. Method according to one of the preceding claims, wherein the determination of the actual data set (Dat_ist) by fitting the simulation target measurement curve (98) to the actual measurement curve (90) in the simulation computer (106) further comprises

(i) Recording (S200) at least one spectral measurement curve with ordinate values and abscissa values as an actual measurement curve (90) on the coating system (10), which consists of one or more individual layers (11, 12, 13, 14, 15, 16, 17, 18, 19, 20) with respective actual coating thicknesses set at the coating system (102) for the production of the coating system (10) (d_ist_11, ..., d_ist_20) set at the coating system (102) for the production of the coating system (10), wherein the one or more individual layers (11, 12, 13, 14, 15, 16, 17, 18, 19, 20) are produced according to the target data set (DAT_soll) of the at least one coating system (102), wherein the target data set (DAT_soll) comprises at least the actual coating system layer thicknesses (d_ist_11, ..., d_ist_20) of the one or more individual layers (11, 12, 13, 14, 15, 16, 17, 18, 19, 20);
(ii) Assigning (S202) the actual measurement curve (90) of the layer system (10) according to an assignment criterion, in particular for significant spectral points of the actual measurement curve (90), to a target measurement curve (92) of the target data set (DAT_soll) with ordinate values and abscissa values, which is based on a target layer system (10_soll) formed from one or more individual layers (11, 12, 13, 14, 15, 16, 17, 18, 19, 20), wherein the target data set (DAT_soll) is assigned at least one known target layer thickness (d_soll_11, ..., d_soll_20) of the respective individual layer (11, 12, 13, 14, 15, 16, 17, 18, 19, 20) of the one or more individual layers (11, 12, 13, 14, 15, 16, 17, 18, 19, 20);
(iii) Generating (S204) a simulation actual measurement curve (94) according to an iterative method by varying at least the simulation actual layer thicknesses (g_ist_11, ..., g_ist_20) of the one or more individual layers (11, 12, 13, 14, 15, 16, 17, 18, 19, 20) in at least one spectral interval (82) of the actual measurement curve (90) and obtaining a final simulation actual data set (DAT_ist_sim) with at least final simulation actual layer thicknesses (g_ist_11, ..., g_ist_20) assigned to the respective individual layers (11, 12, 13, 14, 15, 16, 17, 18, 19, 20), by which the actual measurement curve (90) is at least approximated in the simulation actual measurement curve (94) until a result that is stable according to a statistical selection procedure is achieved for the assignment criterion, wherein as start values for the simulation actual layer thicknesses (g_ist_11, ..., g_ist_20) the target layer thicknesses (d_soll_11, ..., d_soll_20) are used;
(iv) Generating (S206) the simulation target measurement curve (98) according to an iterative procedure by varying at least the simulation target layer thickness (g_soll_11, ..., g_soll_20) assigned to the respective individual layer (11, 12, 13, 14, 15, 16, 17, 18, 19, 20) in at least one spectral interval (82) of the target measurement curve (92) and obtaining a final simulation target data set (DAT_soll_sim) with at least final simulation target layer thicknesses (g_sim_11, ..., g_sim_20) assigned to the respective individual layers (11, 12, 13, 14, 15, 16, 17, 18, 19, 20), by which the target measurement curve (92) is at least approximated in the simulation target measurement curve (98) until a result that is stable according to a statistical selection procedure is achieved for the assignment criterion; wherein the simulation actual layer thicknesses (g_ist_11, ..., g_ist_20) are used as start values for the simulation target layer thicknesses (g_soll_11, ..., g_soll_20);

wherein the iterative procedure is performed for one or more spectral intervals (82, 84, 86), wherein each subsequent interval (84, 86) includes the preceding interval (82, 84).

12. Method according to claim 11, wherein the determination of calculated actual layer parameters (96) by simulating the layer system (10) with the actual data set (Dat_ist) further comprises
Providing (S208) the final simulation target data set (DAT_soll_sim) for the at least one coating system (102) as a new system data set (Dat_ist+1) for the deposition of a further layer system (10_n+1) with at least one or more actual correction layer thicknesses (d_korr_11, ..., d_korr_20) for determining new plant actual layer thicknesses (d_ist_11, ..., d_ist_20), which are determined from the final simulation target layer thicknesses (g_soll_11, ..., g_soll_20) with the final simulation target data set (DAT_soll_sim).

13. Coating system (100) for the self-controlled and feedback-controlled production of coating systems (10), with a method according to at least one of the preceding claims, comprising at least

- a coating system (102) for coating a substrate (22) with a coating system (10) for an optical element (80),
- a control computer (110) for controlling the coating system (102) and for communicating with a simulation computer (106),
- an optical measuring device (104) for determining a spectrally resolved actual measurement curve (90) of the coating system (10),
- a simulation computer (106) on which simulation software (107) for optical calculation and optimization of the coating system (10) is installed,
- a design database (200) for storing target data sets (Dat_soll),
- a storage database (210) for storing actual measurement curves (90), actual data sets (Dat_ist), calculated actual layer parameters (96), and approval decisions,
- a criteria database (220) for storing approval criteria,
- a decision system (108) for approving layer systems (10).

14. Computer program product for a method for self-controlling and feedback-controlled operation of at least one coating system (100) for producing coating systems (10) according to one of claims 1 to 12, wherein the computer program product comprises at least one computer-readable storage medium comprising program instructions executable on a computer system (106) and causing the computer system (106) to execute a method, in particular according to at least claim 1, comprising

(i) causing the coating (S100) of a coating system (10) in a coating plant (102);
(ii) causing the determination (S102) of an actual spectral measurement curve (90) of the coating system (10) in an optical measurement system (104);
(iii) causing the loading (S108) of a target data set (Dat_soll) with a design of the completed coating of the coating system (10) from a design database (200) and the actual measurement curve (90) into a simulation computer (106);
(iv) Causing the determination (S110) of an actual data set (Dat_ist) by fitting a simulation target measurement curve (98) to the actual measurement curve (90) in the simulation computer (106);
(v) causing the determination (S112) of actual layer parameters (96) as calculated actual layer parameters (96) from the simulation target measurement curve (98) by simulating the layer system (10) with the actual data set (Dat_ist) in the simulation computer (106);
(vi) Outputting (S114) the actual data set (Dat_ist) and the calculated actual layer parameters (96) at least to a decision system (108) in the form of a processor or as a process on a control computer (110) of the coating system (100) and to a storage database (210);
(vii) Provision (S118) of quality requirement data based on release criteria for coating systems (10) from a criteria database (220), which are used for comparison of at least the actual data set (Dat_ist), the calculated actual coating parameters (96), and the quality requirement data;
(viii) deciding (S120) on an approval (S122, S124) of the layer system (10) in the decision system (108) based on a comparison of at least the actual data set (Dat_ist), the calculated actual layer parameters (96), and the quality requirement data.

**15.** A data processing system (124) for executing a data processing program comprising a computer program product according to claim 14, for performing a method of operating at least one coating system (100) for producing coating systems (10) according to at least claim 1.

**Revendications**

**1.** Procédé pour l'exploitation autopilotée et à rétroaction d'un système de revêtement (100) pour la fabrication de systèmes de couches (10), comprenant

(i) Enduire (S100) un système de couches (10) dans une installation d'enduction (102) ;
(ii) Déterminer (S102) une courbe de mesure spectrale réelle (90) du système de couches (10) dans un système de mesure optique (104) ;
(iii) chargement (S108) d'un ensemble de données de consigne (Dat_soll) avec une conception du revêtement achevé du système de couches (10) à partir d'une base de données de conception (200) ainsi que de la courbe de mesure réelle (90) dans un ordinateur de simulation (106) ;
(iv) Déterminer (S110) un ensemble de données réelles (Dat_ist) en ajustant une courbe de mesure de consigne de simulation (98) à la courbe de mesure réelle (90) dans l'ordinateur de simulation (106) ;
(v) déterminer (S112) des paramètres de couche réels (96) en tant que paramètres de couche réels calculés (96) à partir de la courbe de mesure de consigne de simulation (98) en simulant le système de couche (10) avec l'ensemble de données réelles (Dat_ist) dans l'ordinateur de simulation (106) ;
(vi) sortie (S114) de l'ensemble de données réelles (Dat_ist) et des paramètres de couche réels calculés (96) au moins vers un système de décision (108) sous la forme d'un processeur ou comme processus sur un ordinateur de commande (110) du système de revêtement (100) et vers une base de données de stockage (210) ;
(vii) fournir (S118) des données d'exigence de qualité basées sur des critères de validation pour des systèmes de couches (10) à partir d'une base de données de critères (220), qui sont utilisées pour comparer au moins l'ensemble de données réelles (Dat_ist), les paramètres de couche réels calculés (96) et les données d'exigence de qualité ;
(viii) décider (S120) d'une validation (S122, S124) du système de quart (10) dans le système de décision (108) sur la base d'une comparaison d'au moins l'ensemble de données réelles (Dat_ist), les paramètres de quart réels calculés (96) et les données d'exigence de qualité.

**2.** Procédé selon la revendication 1, comprenant en outre les étapes consistant à

(i) Calculer (S104) des valeurs de couleur (88) d'une couleur réfléchie résiduelle du système de couches (10) à partir de la courbe de mesure réelle (90) ;
(ii) Stockage (S106) de la courbe de mesure réelle (90) et des valeurs de couleur calculées (88) dans la base de données de stockage (210) ;
(iii) Documenter la décision de libération (S122, S124) dans la base de données de classement (210).

**3.** Procédé selon la revendication 2, dans lequel les critères de validation comprennent au moins des paramètres de couche admissibles et/ou non admissibles, en particulier dont sont déduites des exigences qui sont utilisées pour la comparaison avec l'ensemble de données réelles (Dat_ist) et/ou les paramètres de couche réels calculés (96) et/ou la courbe de mesure réelle (90). en particulier
les données d'exigences de qualité comprenant des valeurs de tolérance pour l'ensemble de données de consigne (Dat_soll) d'un système de couches (10).

**4.** Procédé selon l'une des revendications précédentes, dans lequel la décision de validation du système de couches (10) dans le système de décision (108) comprend une décision de validation automatique basée sur un logiciel, en particulier en utilisant un procédé d'intelligence artificielle.

**5.** Procédé selon l'une des revendications précédentes, comprenant en outre Décider de revêtir un système de couches (10) dans une installation de revêtement (102) sur la base d'une comparaison d'au moins l'ensemble de données de consigne (Dat_soll) et de critères de validation provenant de la base de données de critères (220).

**6.** Procédé selon l'une des revendications précédentes, dans lequel les paramètres de couche réels calculés (96) comprennent des valeurs de réflexion dans des plages de longueurs d'onde en dehors de la courbe de mesure réelle (90), en particulier dans la plage de longueurs d'onde UV, et/ou des valeurs de réflexion sous différents angles d'incidence.

7. Procédé selon l'une des revendications précédentes, dans lequel le revêtement d'un système de couches (10) dans une installation de revêtement (102) comprend le fait qu'un système de couches interférométriques (10) est déposé sur au moins une surface (24) d'un substrat (22),

   le système de couches (10) comprenant une pile (40) d'au moins quatre paquets de couches successifs (42, 44, 46, 48, 50), chaque paquet de couches (42, 44, 46, 48, 50) comprenant une paire de premières et secondes couches individuelles (11, 12, 13, 14, 15, 16, 17, 18, 19, 20), les premières couches individuelles (11, 13, 15, 17, 19) ayant chacune une première épaisseur optique (t1) et les secondes couches individuelles (12, 14, 16, 18, 20) ayant chacune une seconde épaisseur optique (t2) différente de la première épaisseur optique (t1),
   un indice de réfraction (n1) des premières couches individuelles (11, 13, 15, 17, 19) respectivement plus proches du substrat étant supérieur à un indice de réfraction (n2) des secondes couches individuelles (12, 14, 16, 18, 20) respectivement plus éloignées du substrat de l'empilement (40),
   le système de couches (10) présentant une luminosité (L*), une chromaticité (C*) et un angle de chromaticité (h) d'une couleur de réflexion résiduelle,
   la valeur absolue d'une variation (Δh) de l'angle de teinte (h) de la couleur réfléchie résiduelle dans un intervalle d'un angle d'observation (AOI) ayant les valeurs limites de 0° et 30° par rapport à une normale à la surface (70) sur le système de couches (10) étant inférieure à la valeur absolue d'une variation (ΔC*) de la chromaticité (C*) dans l'intervalle de l'angle d'observation (AOI), les étapes suivantes étant effectuées :

      - Définir une conception de couche comprenant au moins un premier matériau pour des premières couches individuelles à haute réfraction (11, 13, 15, 17, 19) et un deuxième matériau pour des deuxièmes couches individuelles à faible réfraction (12, 14, 16, 18, 20), le nombre de paquets de couches souhaités (42, 44, 46, 48, 50) avec les couches individuelles (11, 12, 13, 14, 15, 16, 17, 18, 19, 20), les valeurs de départ de l'épaisseur des couches individuelles (11, 12, 13, 14, 15, 16, 17, 18, 19, 20) ;
      - Définir des valeurs de couleur cibles, comprenant la luminosité (L*), la chromaticité (C*) et l'angle de teinte (h), au moins à des valeurs limites pour un intervalle d'un angle d'observation (AOI) ayant des valeurs limites de 0° et 30°;
      - Exécuter une procédure d'optimisation pour faire varier les épaisseurs des couches individuelles (d_ist_11, ..., d_ist 20) jusqu'à ce qu'un objectif d'optimisation soit atteint.

8. Procédé selon la revendication 7, dans lequel l'angle de teinte (h) dans l'intervalle de l'angle d'observation (AOI) avec les valeurs limites de 0° et 30° varie d'au plus 15°, de préférence d'au plus 10° ;
   et/ou

   la valeur de la variation (Δh) de l'angle de teinte (h) dans un deuxième intervalle d'un angle d'observation (AOI) de 0° jusqu'à un angle d'observation limite (Θ) ayant des valeurs limites supérieures comprises entre au moins 30° et au plus 45° par rapport à la normale à la surface (70) sur le système de couches (10) est inférieure à la valeur d'un changement (ΔC*) de la coloration (C*) dans le deuxième intervalle de l'angle d'observation (AOI) et la valeur de la coloration (C*) à l'angle d'observation limite (Θ) est au moins 2, en particulier, l'angle de chromaticité (h) dans le deuxième intervalle changeant au plus de 20°, de préférence au plus de 15° ;
   et/ou
   la réflectance photopique (Rv) dans l'intervalle de l'angle d'observation (AOI) avec les valeurs limites de 0° et 30° étant au plus de 1,5%, de préférence au plus de 1,2% ;
   et/ou
   la réflectance scotopique (Rv') dans l'intervalle de l'angle d'observation (AOI) avec les valeurs limites de 0° et 30° étant au plus de 1,5%, de préférence au plus de 1,2%.

9. Procédé selon l'une des revendications précédentes, dans lequel, pour la détermination de la courbe de mesure spectrale réelle (90) du système de couches (10) dans un système de mesure optique (104), une mesure de réflexion spectrale est effectuée sur le système de couches (10).

10. Procédé selon l'une quelconque des revendications 2 à 9, dans lequel le calcul de valeurs de couleur (88) d'une couleur réfléchie résiduelle du système de couches (10) à partir de la courbe de mesure réelle (90) comprend en outre la détermination d'une luminosité (L*), d'une chromaticité (C*) et d'un angle de teinte (h) de la couleur réfléchie résiduelle à partir de la courbe de mesure réelle (90).

11. Procédé selon l'une quelconque des revendications précédentes, dans lequel la détermination de l'ensemble de données réelles (Dat_ist) par l'ajustement de la courbe de mesure cible de simulation (98) à la courbe de mesure réelle (90) dans l'ordinateur de simulation (106) comprend en outre

(i) saisie (S200) d'au moins une courbe de mesure spectrale avec des valeurs d'ordonnées et des valeurs d'abscisses comme courbe de mesure réelle (90) sur le système de couches (10) qui est constitué d'une ou de plusieurs couches individuelles (11, 12, 13, 14, 15, 16, 17, 18, 19, 20) avec des épaisseurs de couche réelles d'installation respectives (d_ist_11, ...d_ist_20), une ou plusieurs couches individuelles (11, 12, 13, 14, 15, 16, 17, 18, 19, 20) étant fabriquées selon l'ensemble de données de consigne (DAT_soll) de la au moins une installation de revêtement (102), l'ensemble de données de consigne (DAT_soll) comprenant au moins les épaisseurs de couche réelles d'installation (d_ist_11, ...d_ist_20) d'une ou de plusieurs couches individuelles (11, 12, 13, 14, 15, 16, 17, 18, 19, 20) ;

(ii) l'affectation (S202) de la courbe de mesure réelle (90) du système de couches (10) selon un critère d'affectation, en particulier pour des points spectraux significatifs de la courbe de mesure réelle (90), à une courbe de mesure de consigne (92) du jeu de données de consigne (DAT_soll) avec des valeurs d'ordonnées et des valeurs d'abscisses, qui correspond à un système de couches de consigne (10_soll), formé d'une ou de plusieurs couches individuelles (11, 12, 13, 14, 15, 16, 17, 18, 19, 20), le jeu de données de consigne (DAT_soll) étant basé sur au moins une épaisseur de couche de consigne connue (d_soll_11, ...d_soll_20) de la ou des couches individuelles (11, 12, 13, 14, 15, 16, 17, 18, 19, 20) ;

(iii) générer (S204) une courbe de mesure réelle de simulation (94) selon un procédé itératif en faisant varier au moins des épaisseurs de couche réelles de simulation (g_ist_11, ...g_ist_20) d'une ou plusieurs couches individuelles (11, 12, 13, 14, 15, 16, 17, 18, 19, 20) dans au moins un intervalle spectral (82) de la courbe de mesure réelle (90) et obtention d'un jeu de données réel de simulation final (DAT_ist_sim) avec au moins des épaisseurs de couches réelles de simulation finales (g_ist_11, ..., g_ist_20), par lesquelles la courbe de mesure réelle (90) est au moins approchée dans la courbe de mesure réelle de simulation (94) jusqu'à ce qu'un résultat stable selon un procédé de sélection statistique soit atteint pour le critère d'attribution, les épaisseurs de couche de consigne (d_soll_11, ..., d_soll_20) étant utilisées comme valeurs de départ des épaisseurs de couche réelles de simulation (g_ist_11, ..., g_ist_20) ;

(iv) générer (S206) la courbe de mesure de consigne de simulation (98) selon un procédé itératif en faisant varier au moins l'épaisseur de couche de consigne de simulation (g_soll_11, ...g_soll_20) de la ou des couches individuelles (11, 12, 13, 14, 15, 16, 17, 18, 19, 20) dans au moins un intervalle spectral (82) de la courbe de mesure théorique (92) et obtention d'un jeu de données théorique de simulation final (DAT_soll_sim) avec au moins des épaisseurs de couche théorique de simulation finales (g_soll_11, ...g_soll_20, par lesquelles la courbe de mesure de consigne (92) est au moins approchée dans la courbe de mesure de consigne de simulation (98), jusqu'à ce qu'un résultat stable selon un procédé de sélection statistique soit atteint pour le critère d'attribution ; les épaisseurs de couche réelles de simulation (g_ist_11, ..., g_ist_20) étant utilisées comme valeurs de départ des épaisseurs de couche de consigne de simulation (g_soll_11, ..., g_soll_20) ;

le procédé itératif étant effectué pour un ou plusieurs intervalles spectraux (82, 84, 86), chaque intervalle suivant (84, 86) incluant l'intervalle précédent (82, 84).

12. Procédé selon la revendication 11, dans lequel la détermination de paramètres de couche réels calculés (96) par simulation du système de couche (10) avec l'ensemble de données réelles (Dat_ist) comprend en outre mise à disposition (S208) du jeu de données de consigne de simulation final (DAT_soll_sim) pour l'au moins une installation de revêtement (102) comme nouveau jeu de données d'installation (Dat_ist+1) pour le dépôt d'un autre système de couches (10_n+1) avec au moins une ou plusieurs épaisseurs de couches réelles de correction (d_korr_11, ..., d_korr_20) pour la détermination de nouvelles épaisseurs de couche réelles d'installation (d_ist_11, ..., d_ist_20), qui sont déterminées à partir des épaisseurs de couche de consigne de simulation finales (g_soll_11, ..., g_soll_20) avec le jeu de données de consigne de simulation finales (DAT_soll_sim).

13. Système de revêtement (100) pour la fabrication autopilotée et rétroactive de systèmes de couches (10), avec un procédé selon au moins l'une des revendications précédentes, comprenant au moins

- une installation de revêtement (102) pour revêtir un substrat (22) d'un système de couches (10) pour un élément optique (80),
- un ordinateur de commande (110) pour commander l'installation de revêtement (102) et pour communiquer avec un ordinateur de simulation (106),

- un appareil de mesure optique (104) pour déterminer une courbe de mesure réelle (90), résolue spectralement, du système de couches (10),

- un ordinateur de simulation (106), sur lequel est installé un logiciel de simulation (107) pour le calcul optique et l'optimisation du système de couches (10),

- une base de données de conception (200) pour le stockage des enregistrements de données de consigne (Dat_soll),

- une base de données de stockage (210) pour le stockage des courbes de mesure réelles (90), des enregistrements de données réelles (Dat_ist), des paramètres de stratification réels calculés (96) et des décisions de validation,

- une base de données de critères (220) pour stocker les critères de libération,

- un système de décision (108) pour la validation des systèmes d'équipes (10).

14. Produit-programme informatique pour un procédé de fonctionnement autopiloté et rétroactif d'au moins un système de revêtement (100) pour la fabrication de systèmes de couches (10) selon l'une des revendications 1 à 12, le produit-programme informatique comprenant au moins un support de stockage lisible par ordinateur, qui comprend des instructions de programme qui sont exécutables sur un système informatique (106) et qui amènent le système informatique (106) à exécuter un procédé, en particulier selon au moins la revendication 1, comprenant

(i) Effectuer le revêtement (S100) d'un système de couches (10) dans une installation de revêtement (102) ;

(ii) Procéder à la détermination (S102) d'une courbe de mesure spectrale réelle (90) du système de revêtement (10) dans un système de mesure optique (104) ;

(iii) effectuer le chargement (S108) d'un ensemble de données de consigne (Dat_soll) avec un design du revêtement terminé du système de couches (10) à partir d'une base de données de design (200) ainsi que de la courbe de mesure réelle (90) dans un ordinateur de simulation (106) ;

(iv) effectuer la détermination (S110) d'un ensemble de données réelles (Dat_ist) en calant une courbe de mesure cible de simulation (98) sur la courbe de mesure réelle (90) dans l'ordinateur de simulation (106) ;

(v) effectuer la détermination (S112) de paramètres de stratification réels (96) en tant que paramètres de stratification réels calculés (96) à partir de la courbe de mesure de consigne de simulation (98) en simulant le système de stratification (10) avec l'ensemble de données réelles (Dat_ist) dans l'ordinateur de simulation (106) ;

(vi) sortie (S114) de l'ensemble de données réelles (Dat_ist) et des paramètres de couche réels calculés (96) au moins vers un système de décision (108) sous la forme d'un processeur ou comme processus sur un ordinateur de commande (110) du système de revêtement (100) et vers une base de données de stockage (210) ;

(vii) fournir (S118) des données d'exigence de qualité basées sur des critères de validation pour des systèmes de couches (10) à partir d'une base de données de critères (220), qui sont utilisées pour comparer au moins l'ensemble de données réelles (Dat_ist), les paramètres de couche réels calculés (96) et les données d'exigence de qualité ;

(viii) décider (S120) d'une validation (S122, S124) du système de quart (10) dans le système de décision (108) sur la base d'une comparaison d'au moins l'ensemble de données réelles (Dat_ist), les paramètres de quart réels calculés (96) et les données d'exigence de qualité.

15. Système de traitement de données (124) pour l'exécution d'un programme de traitement de données, qui comprend un produit programme d'ordinateur selon la revendication 14, pour l'exécution d'un procédé d'exploitation d'au moins un système de revêtement (100) pour la fabrication de systèmes de couches (10) selon au moins la revendication 1.

Fig. 1

Fig. 2

| No. | Text | Num. | Req. |
|-----|------|------|------|
| 1.1 | T1 | N1 | R1 |
| 1.2 | T2 | N2 | R2 |
| 1.3 | T3 | N3 | R3 |
| 1.4 | T4 | N4 | R4 |

Fig. 3

Fig. 4

Fig. 5

Fig. 6

Fig. 7

Fig. 8

Fig. 9

Fig. 10

Fig. 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2016110339 A1
- US 2019127845 A1